# EUROPEAN PATENT APPLICATION

(11) **EP 4 543 167 A2**
(43) Date of publication of application: **23.04.2025**
(21) Application number: 25162722.0
(22) Date of filing: 10.03.2025
(51) Int. Cl.: H10F 10/14, H10F 77/20, H10F 77/30

(54) **BACK-CONTACT SOLAR CELL, PREPARATION METHOD THEREOF, AND PHOTOVOLTAIC MODULE**

(30) Priority: 28.11.2024 CN 202411728853
(71) Applicant: Trina Solar Co., Ltd, Changzhou, Jiangsu 213031 (CN)
(72) Inventor: WANG, Tianyu, Changzhou, 213031 (CN); LIU, Wei, Changzhou, 213031 (CN); WANG, Yuhang, Changzhou, 213031 (CN)
(74) Representative: Arnold & Siedsma

(57) **Abstract**

The present application relates to a back-contact solar cell, a preparation method thereof, and a photovoltaic module. The back-contact solar cell includes a substrate, a first emitter structure disposed on a first surface of the substrate, and a second emitter structure disposed on the first surface of the substrate. The doping type of the first emitter structure is opposite to the doping type of the second emitter structure. The first emitter structure and the second emitter structure are alternately disposed and spaced apart from each other in a first preset direction. An insulative isolating groove is defined between the first emitter structure and the second emitter structure that are adjacent to each other. The back-contact solar cell further includes a marking structure disposed in the insulative isolating groove and spaced apart from both the first emitter structure and the second emitter structure.

## Description

### TECHNICAL FIELD

The present application relates to the technical field of photovoltaics, and particularly to a back-contact solar cell, a preparation method thereof, and a photovoltaic module.

### BACKGROUND

Back-contact solar cells emerged in the 1970s, including interdigitated p-type and n-type regions on the back side of the cell. Positive and negative electrodes are both formed on the back side of the cell. With no metal shading on the front side, the optical absorption of the cell is significantly improved. The preparation of the back-contact solar cell is more complex than that of a bifacial cell, and requires higher precision in back side fabrication. Therefore, a marking structure needs to be arranged on the back side of the cell as a positioning reference to assist in patterning and wafer alignment.

### SUMMARY

In view of the above, there is a need to provide a back-contact solar cell, a preparation method thereof, and a photovoltaic module.

An aspect of embodiments of the present application provides a back-contact solar cell, including:
a substrate;
a first emitter structure disposed on a first surface of the substrate;
a second emitter structure disposed on the first surface of the substrate, wherein a doping type of the first emitter structure is opposite to a doping type of the second emitter structure, the first emitter structure and the second emitter structure are alternately disposed and spaced apart from each other in a first preset direction, and an insulative isolating groove is defined between the first emitter structure and the second emitter structure; and
a marking structure disposed in the insulative isolating groove and spaced apart from both the first emitter structure and the second emitter structure.

In some embodiments, a bottom of the insulative isolating groove includes a first portion and a second portion, the first portion extends to the first surface in a thickness direction of the substrate, the marking structure is located at the second portion and protrudes from the first surface towards a direction away from the substrate along the thickness direction of the substrate.

In some embodiments, a reflectivity of a surface of the marking structure away from the substrate is different from a reflectivity of a surface of the first portion.

In some embodiments, the reflectivity of the surface of the marking structure away from the substrate is greater than the reflectivity of the surface of the first portion.

In some embodiments, the surface of the marking structure away from the substrate is a polished surface;
at least a part of the surface of the first portion has a textured surface structure.

In some embodiments, an average roughness of the surface of the marking structure away from the substrate is less than an average roughness of the surface of the first portion.

In some embodiments, the marking structure at least includes a doped layer, which is substantially same as a doped layer of the first emitter structure; or
the marking structure at least includes a doped layer, which is substantially same as a doped layer of the second emitter structure.

In some embodiments, the first emitter structure includes a first tunneling oxide layer and a first doped polysilicon layer, the first tunneling oxide layer and the first doped polysilicon layer are stacked on the first surface;
the marking structure includes a first layer and a second layer, the first layer and the second layer are stacked on the first surface, the first layer and the first tunneling oxide layer are made of a same material, and the second layer and the first doped polysilicon layer are made of a same material.

In some embodiments, the second emitter structure includes a second tunneling oxide layer and a second doped polysilicon layer, the second tunneling oxide layer and the second doped polysilicon layer are stacked on the first surface;
the marking structure includes a first layer and a second layer, the first layer and the second layer are stacked on the first surface, the first layer and the second tunneling oxide layer are made of a same material, and the second layer and the second doped polysilicon layer are made of a same material.

In some embodiments, a layer structure of the marking structure is different from a layer structure of the first emitter structure, and is different from a layer structure of the second emitter structure.

In some embodiments, a surface of the marking structure away from the substrate is in a circular, annular, or polygonal shape; or,
a surface of the marking structure away from the substrate is in a shape including at least two strips intersecting with each other.

In some embodiments, the surface of the marking structure away from the substrate is in a polygonal shape, and an edge of the polygonal shape has a length in a range from 50 µm to 950 µm.

In some embodiments, the back-contact solar cell further includes a first passivation layer;
the first passivation layer is disposed on a surface of the first emitter structure and a surface of the second emitter structure away from the substrate and covers the marking structure.

In some embodiments, a distance between the marking structure and the first emitter structure is greater than 20 µm, and a distance between the marking structure and the second emitter structure is greater than 20 µm.

In some embodiments, the substrate includes a first inward diffusion layer and a second inward diffusion layer extend from the first surface, a doping type of a dopant in the first inward diffusion layer is same as that of a dopant in the first emitter structure, and a doping type of a dopant in the second inward diffusion layer is same as that of a dopant in the second emitter structure;
the first inward diffusion layer is located at a position corresponding to the first emitter structure and the marking structure, and the second inward diffusion layer is located at a position corresponding to the second emitter structure.

In some embodiments, a thickness of the first inward diffusion layer is greater than a thickness of the second inward diffusion layer.

In some embodiments, the thickness of the first inward diffusion layer is in a range from 50 nm to 200 nm, and the thickness of the second inward diffusion layer is in a range from 20 nm to 100 nm.

In some embodiments, the back-contact solar cell further includes a first electrode and a second electrode;
the first electrode is disposed on a side of the first emitter structure away from the substrate, and is electrically connected to a doped layer of the first emitter structure;
the second electrode is disposed on a side of the second emitter structure away from the substrate, and is electrically connected to a doped layer of the second emitter structure.

In some embodiments, the first emitter structure includes a first main structure and first digit structures, and the second emitter structure includes a second main structure and second digit structures;
the first main structure of the first emitter structure and the second main structure of the second emitter structure are alternately disposed and spaced apart from each other in the first preset direction;
each first main structure is connected to at least two of the first digit structures, the at least two of the first digit structures are spaced apart from each other in a second preset direction, and each second main structure is connected to at least two of the second digit structures, the at least two of the second digit structures are spaced apart from each other in the second preset direction, and the first preset direction and the second preset direction intersect with each other and are both perpendicular to a thickness direction of the back-contact solar cell;
the first digit structures and the second digit structures that are located between the first main structure and the second main structure that are adjacent to each other are interdigitated with each other in the first preset direction;
the marking structure is located in a region where the first digit structure and the second digit structure that are interdigitated with each other.

In some embodiments, the marking structure is located between one first digit structure and one second digit structure adjacent to each other in the second preset direction.

In some embodiments, the first digit structures and the second digit structures located between the first main structure and the second main structure are alternately disposed in the second preset direction;
the marking structure is located at an end of a first digit structure away from the first main structure in the first preset direction; or
the marking structure is located at an end of the second digit structure away from the second main structure in the first preset direction.

In some embodiments, the marking structure is located at an end of the second digit structure away from the second main structure in the first preset direction;
the first emitter structure further includes a first connecting structure, and two adjacent first digit structures are connected to each other via the first connecting structure in the second present direction;
the marking structure is located between the first connecting structure and a corresponding second digit structure in the first preset direction, and the second digit structure is inserted between the two adjacent first digit structures in the second preset direction.

In some embodiments, the marking structure is located at the end of the first digit structure away from the first main structure in the first preset direction; the second emitter structure further includes a second connecting structure, and two adjacent second digit structures are connected to each other via the second connecting structure in the second present direction; and
the marking structure is located between the second connecting structure and a corresponding first digit structure in the first preset direction, and the corresponding first digit structure is inserted between the two adjacent second digit structures in the second preset direction.

In some embodiments, the first electrode includes a first busbar and first finger electrodes electrically connected to the first busbar, the second electrode includes a second busbar and second finger electrodes electrically connected to the second busbar; and
the first busbar and the first finger electrodes are correspondingly disposed on the first main structure and the first digit structures, respectively, and the second busbar and the second finger electrodes are correspondingly disposed on the second main structure and the second digit structures, respectively.

In some embodiments, the first electrode includes a first busbar and first finger electrodes, and the second electrode includes a second busbar and second finger electrodes;
the first busbar and the second busbar are alternately disposed and spaced apart from each other in the first preset direction;
each first busbar is connected to at least two of the first finger electrodes, the at least two of the first finger electrodes are spaced apart from each other in a second preset direction, each second busbar is connected to at least two of the second finger electrodes, the at least two of the first finger electrodes are spaced apart from each other in a second preset direction, and the first preset direction and the second preset direction intersect with each other and are both perpendicular to a thickness direction of the back-contact solar cell;
the first finger electrodes and the second finger electrodes located between the first busbar and the second busbar are interdigitated with each other; and
the marking structure is located in a region where the first finger electrode and the second finger electrodes are interdigitated with each other.

In some embodiments, the marking structure is located between one first finger electrode and one second finger electrode adjacent to each other in the second preset direction.

In some embodiments, the first finger electrodes and the second finger electrodes located between the first busbar and the second busbar are alternately disposed in the second preset direction;
the marking structure is located at an end of one first finger electrode away from the first busbar in the first preset direction, and a distance between a center of the marking structure and the first busbar is greater than or equal to a distance between the center of the marking structure and the second busbar; or
the marking structure is located at an end of one second finger electrode away from the second busbar in the first preset direction, and a distance between a center of the marking structure and the second busbar is greater than or equal to a distance between the center of the marking structure and the first busbar.

In some embodiments, both the first finger electrodes and the second finger electrodes extend in the first preset direction;
the marking structure is located at an end of the second finger electrode away from the second busbar in the first preset direction;
the first electrode further includes a first connecting line located between two adjacent first finger electrodes, the marking structure is located between the second finger electrode and the first connecting line in the first preset direction, and the second finger electrode is inserted between the two adjacent first finger electrodes in the second preset direction.

In some embodiments, the marking structure is located at an end of the first finger electrode away from the first busbar in the first preset direction;
the second electrode further includes a second connecting line located between two adjacent second finger electrodes, the marking structure is located between the first finger electrode and the second connecting line in the first preset direction, and the first finger electrode is inserted between the two adjacent second finger electrodes in the second preset direction.

Another aspect of embodiments of the present application provides a method for preparing a back-contact solar cell, including:
forming a first emitter structure and a marking structure respectively on a first region and a marking region of a first surface of a substrate, with a first mask pattern being stacked on a surface of the first emitter structure and a surface of the marking structure away from the substrate, wherein the first surface further comprises a second region and an isolating region, the first region and the second region are alternately arranged in a first preset direction, the isolating region is located between the first region and the second region adjacent to each other, thereby isolating the first region from the second region, the marking region is located in the isolating region, and an outer contour of the marking region is spaced apart from an outer contour of the isolating region;
forming a second emitter material layer and a second mask material layer covering at least an entire first surface, wherein the second emitter material layer and the second mask material layer are stacked on a side of the first mask pattern away from the substrate; and
taking the marking structure, and the portion of the first mask pattern, the second emitter material layer, and the second mask material layer that is stacked on the marking structure as a positioning reference, forming the portion of the second emitter material layer located in the second region into a second emitter structure, and forming an insulative isolating groove corresponding to the isolating region and between the first emitter structure and the second emitter structure.

In some embodiments, forming the second emitter structure and the insulative isolating groove comprises:
taking the marking structure, and the portion of the first mask pattern, the second emitter material layer, and the second mask material layer that is stacked on the marking structure as the positioning reference, removing a portion of the second mask material layer covering the first region and the isolating region;
further patterning the second mask material layer to retain the portion of the second mask material layer corresponding to the second region to form a second mask pattern; and
etching the second emitter material layer into the second emitter structure covering the second region through the second mask pattern as a mask, by which the insulative isolating groove is formed corresponding to the isolating region and between the first emitter structure and the second emitter structure.

In some embodiments, removing the portion of the second mask material layer covering the first region and the isolating region comprises:
with a layer stack composed by the marking structure, and the portion of the first mask pattern, the second emitter material layer, and the second mask material layer stacked on the marking structure as the positioning reference, removing the portion of the second mask material layer covering the first region and the isolating region through laser etching.

In some embodiments, the second emitter material layer and the second mask material layer are further formed on a second surface and a side surface of the substrate, the second surface is disposed opposite to the first surface, the side surface is located adjacent to and connected with both the first surface and the second surface;
further patterning the second mask material layer to retain the portion of the second mask material layer corresponding to the second region to form the second mask pattern comprises:
removing the portion of the second mask material layer covering the side surface and the second surface through washing with an acidic solution.

In some embodiments, forming the second emitter structure and the insulative isolating groove comprises:
wet etching the second emitter material layer with an alkaline solution through the second mask pattern as a mask to form the second emitter structure and the insulative isolating groove.

In some embodiments, the isolating region excluding the marking region is defined as a target region, wet etching the second emitter material layer with the alkaline solution through the second mask pattern as a mask comprises:
removing the portions of the second emitter material layer covering the first region and the isolating region and texturing a surface of substrate in the target region into a textured surface structure with the alkaline solution.

In some embodiments, forming the first emitter structure and the marking structure comprises:
forming a first emitter material layer and a first mask material layer stacked on at least the first surface of the substrate;
patterning the first mask material layer into the first mask pattern covering the marking region and the first region; and
etching the first emitter material layer through the first mask pattern as a mask to form the first emitter structure and the marking structure.

In some embodiments, the first emitter material layer and the first mask material layer are also formed on a second surface and a side surface of the substrate, the second surface is disposed opposite to the first surface, the side surface is located adjacent to and connected with both the first surface and the second surface, and the isolating region excluding the marking region is defined as a target region;
patterning the first mask material layer into the first mask pattern comprises:
removing the portion of the first mask material layer covering the second region and the target region through laser etching; and
removing the portion of the first mask material layer covering the side surface and the second surface through washing with an acidic solution.

In some embodiments, removing the portion of the first mask material layer covering the target region through laser etching comprises:
scanning the isolating region with a laser, including turning off the laser for a preset time when scanning reaches the marking region, and turning on the laser until when scanning reaches the target region.

In some embodiments, forming the first emitter material layer and the first mask material layer stacked on at least the first surface of the substrate comprises:
forming a first tunneling material layer and a first doped polysilicon material layer in sequence as the first emitter material layer stacked on the surfaces of the substrate, and forming a first oxide material layer as a first mask material layer on a surface of the first doped polysilicon material layer away from the substrate.

In some embodiments, forming the second emitter material layer and the second mask material layer covering at least the entire first surface and stacked on the side of the first mask pattern away from the substrate comprises:
forming a second tunneling material layer and a second doped polysilicon material layer in sequence as the second emitter material layer stacked on each surface of the substrate, and forming a second oxide material layer as the second mask material layer on a surface of the second doped polysilicon material layer away from the substrate.

In some embodiments, the isolating region excluding the marking region is defined as a target region, and a surface of the target region has a textured surface structure;
after forming the second emitter structure and the insulative isolating groove, the method further comprises:
removing the second mask material layer covering the first mask pattern and the second emitter structure layer; and
forming a first passivation layer on a side of the first emitter structure, the second emitter structure, and the marking structure away from the substrate, wherein the first passivation layer covers the entire first surface.

In some embodiments, after forming the first passivation layer, the method further comprises:
taking the marking structure and the portion of the first passivation layer that is stacked on the marking structure as a positioning reference, forming a first electrode and a second electrode on the first passivation layer corresponding to the first emitter structure and the second emitter structure, respectively, wherein the first electrode is electrically connected to the first emitter structure, and the second electrode is electrically connected to the second emitter structure.

Yet another aspect of embodiments of the present application provides a back-contact solar cell prepared by the above-described method for preparing the back-contact solar cell.

Yet another aspect of embodiments of the present application provides a photovoltaic module including at least one cell string, wherein the cell string includes at least two back-contact solar cells as described above.

The above-described back-contact solar cell, the preparation method thereof, and photovoltaic module have beneficial effects as follows:

The marking structure is disposed in the insulative isolating groove, and is spaced apart from both the first emitter structure and the second emitter structure. In other words, the marking structure is spaced apart from both the first emitter structure and the second emitter structure which surround the marking structure, making the marking structure be spaced apart from the side wall of the insulative isolating groove adjacent thereto, thus allowing the marking structure to be formed into an isolated island structure in the insulative isolating groove. Compared with related art, where the marking structure is formed on the p-type doped layer or the n-type doped layer, rendering easy confusion between the outer contours of the marking structure and the p-type doped layer or the n-type doped layer, the marking structure in the present application can avoid confusion with the first emitter structure and the second emitter structure. During the positioning process, this marking structure can be captured and recognized easily, thereby ensuring a relatively high positioning precision, and thus further improving the yield of production of the back-contact solar cells.

### BRIEF DESCRIPTION OF THE DRAWINGS

FIG. 1 is a schematic view showing a location of a marking structure in related art.
FIG. 2A is a schematic structural view of a back-contact solar cell according to an embodiment of the present application.
FIG. 2B is another schematic view of the back-contact solar cell according to the embodiment of the present application.
FIG. 2C is yet another schematic view of the back-contact solar cell according to the embodiment of the present application.
FIG. 3 is a schematic structural top view of a first emitter structure and a second emitter structure of a back-contact solar cell according to an embodiment of the present application.
FIG. 4 is a schematic view showing a location of a marking structure in a back-contact solar cell according to another embodiment of the present application.
FIG. 5 is a schematic view showing a location of a marking structure in a back-contact solar cell according to still another embodiment of the present application.
FIG. 6 is a schematic structural view of a back-contact solar cell according to yet another embodiment of the present application.
FIG. 7 shows a flow chart of a method for preparing a back-contact solar cell according to an embodiment of the present application.
FIG. 8 is a schematic view of forming a first tunneling material layer, a first doped polysilicon material layer, and a first mask material layer in a method for preparing a back-contact solar cell according to an embodiment of the present application.
FIG. 9 is a schematic view of patterning at a first surface of a substrate in a method for preparing a back-contact solar cell according to an embodiment of the present application.
FIG. 10 is a schematic view of removing a first mask material layer from a side surface and a second surface in a method for preparing a back-contact solar cell according to an embodiment of the present application.
FIG. 11 is a schematic view of a first emitter structure and a marking structure in a method for preparing a back-contact solar cell according to an embodiment of the present application.
FIG. 12 is a schematic view of forming a second tunneling material layer, a second doped polysilicon material layer, and a second mask material layer in a method for preparing a back-contact solar cell according to an embodiment of the present application.
FIG. 13 shows an optical image of a marking structure, after forming a second tunneling material layer, a second doped polysilicon material layer and a second mask material layer.
FIG. 14 shows a three-dimensional structural optical image of the marking structure, after forming the second tunneling material layer, the second doped polysilicon material layer and the second mask material layer.
FIG. 15 is a schematic view of forming a second mask pattern in a method for preparing a back-contact solar cell according to an embodiment of the present application.
FIG. 16 is a schematic view of forming a second emitter structure in a method for preparing a back-contact solar cell according to an embodiment of the present application.
FIG. 17 shows an optical image of a marking structure, after forming a second emitter structure.
FIG. 18 shows a three-dimensional structural optical image of the marking structure, after forming the second emitter structure.
FIG. 19 is a schematic view of forming a first passivation layer and a second passivation layer in a method for preparing a back-contact solar cell according to an embodiment of the present application.

### Reference signs:

100: back-contact solar cell;
10: substrate; 20: first emitter structure; 201: first main structure; 202: first digit structure; 203: first connecting structure; 205: first inward diffusion layer; 21: first tunneling oxide layer; 22: first doped polysilicon layer; 30: second emitter structure; 301: second main structure; 302: second digit structure; 303: second connecting structure; 304: second inward diffusion layer; 31: second tunneling oxide layer; 32: second doped polysilicon layer; 40: insulative isolating groove; 41: textured surface structure; 401: first portion; 402: second portion; 50 and 101: marking structure; 51: first layer; 52: second layer;
61: first passivation layer; 62: second passivation layer; 621: passivation layer; 622: anti-reflection layer;
70: first emitter material layer; 71: first tunneling material layer; 72: first doped polysilicon material layer; 73: first mask material layer; 730: first mask pattern;
80: second emitter material layer; 81: second tunneling material layer; 82: second doped polysilicon material layer; 83: second mask material layer; 830: second mask pattern;
91: first electrode; 911: first busbar; 912: first finger electrode; 913: first connecting line; 92: second electrode; 921: second busbar; 922: second finger electrode; 923: second connecting line;
102: p-type doped layer; 103: n-type doped layer; 104: finger electrode;
F: first surface; S: second surface; C: side surface; Y: first region; E: second region; G: isolating region; T: target region; B: marking region; F1: first preset direction; F2: second preset direction.

### DETAILED DESCRIPTION

The embodiments of the present application will be described in detail with reference to the accompanying drawings in order to make the objects, features, and advantages of the present application more apparent and understandable. Many specific details are disclosed in the following description to facilitate a comprehensive understanding of the present application. However, the present application can be implemented in various ways different from those described herein, and those skilled in the art may make similar improvements without departing from the scope of the present application. Therefore, the present application is not limited to the specific embodiments disclosed below.

In the description of the present application, it should be understood that the orientation or position relationships indicated by the terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", and the like are based on the orientation or position relationships shown in the accompanying drawings and are intended to facilitate the description of the present application and simplify the description only, rather than indicating or implying that the apparatus or element referred to must have a particular orientation or be constructed and operated in a particular orientation, and therefore are not to be interpreted as limiting the present application. In addition, the drawings are not necessarily drawn to scale, and various parts are drawn for better illustration of the embodiments.

In addition, the terms "first" and "second" are used for descriptive purposes only, and cannot be construed as indicating or implying a relative importance, or implicitly specifying the number of the indicated technical features. Thus, the quantity of the feature defined with "first" or "second" may explicitly or implicitly be at least one. In the description of the present application, "a plurality of" means at least two, such as two, three, unless otherwise defined explicitly and specifically.

In the present application, unless otherwise specified and defined explicitly, the terms "install", "connect", "join", and "fix" should be interpreted in a broad sense. For example, unless otherwise defined explicitly, they may refer to a fixed connection, a detachable connection, or an integral connection, may refer to a mechanical connection or an electrical connection, and may refer to a direct connection, an indirect connection via an intermediate medium, an internal communication between two elements, or interaction between two elements. The specific meanings of these terms in the present application can be understood based on specific circumstances by those of ordinary skills in the art.

In the present application, unless otherwise specified and defined explicitly, a first feature, when expressed as being "on" or "under" a second feature, may be in direct contact with the second feature or in indirect contact with the second feature via an intermediate medium. Furthermore, a first feature, when expressed as being "over", "above" or "on top of" a second feature, may be located right above or obliquely above the second feature, or just located at a level higher than that of the second feature. A first feature, when expressed as being "below", "underneath" or "under" a second feature, may be located right below or obliquely below the second feature, or just located at a level lower than that of the second feature.

It should be noted that when an element is referred to as being "fixed to" or "arranged on" another element, it may be directly disposed on the other element or an intermediate element may exist. When an element is considered to be "connected to" another element, it may be directly connected to the other element or an intermediate element may also exist. The terms "vertical", "horizontal", "upper", "lower", "left", "right" and similar expressions used herein are only for illustrative purposes and are not intended to represent the only implementations.

Hereinafter, embodiments of back-contact solar cells, preparation methods thereof and photovoltaic modules of the present application will be described with reference to the accompanying drawings. It should be noted that in the present application, TOPCon cells with back contact (TBCs) are taken as examples of the back-contact solar cells for description. However, the back-contact solar cells can be other types of cells, such as heterojunction cells with back contact (HBC), according to actual needs. The back-contact solar cells of other types can have similar corresponding structures, and will not be repeatedly described herein.

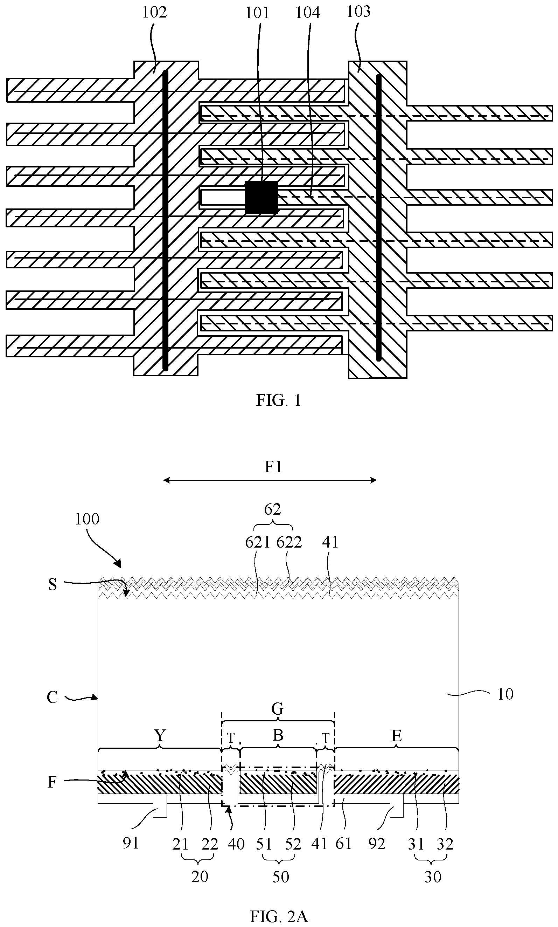

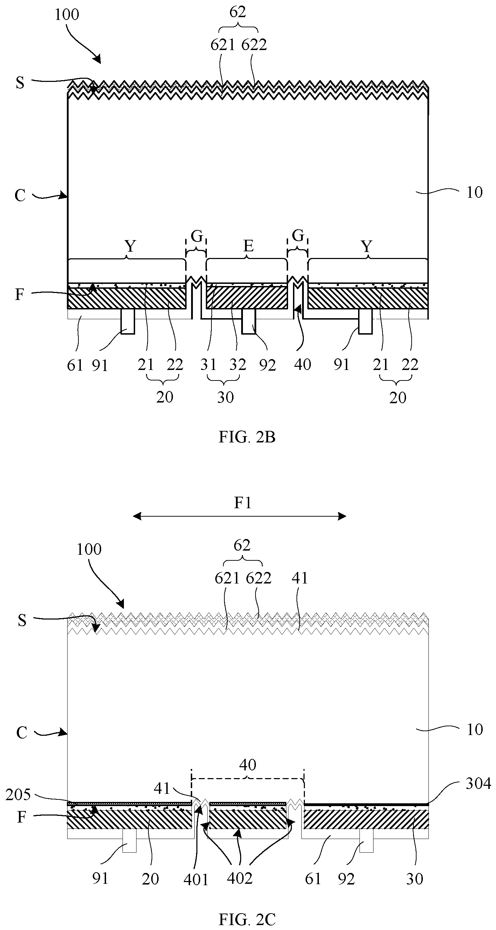

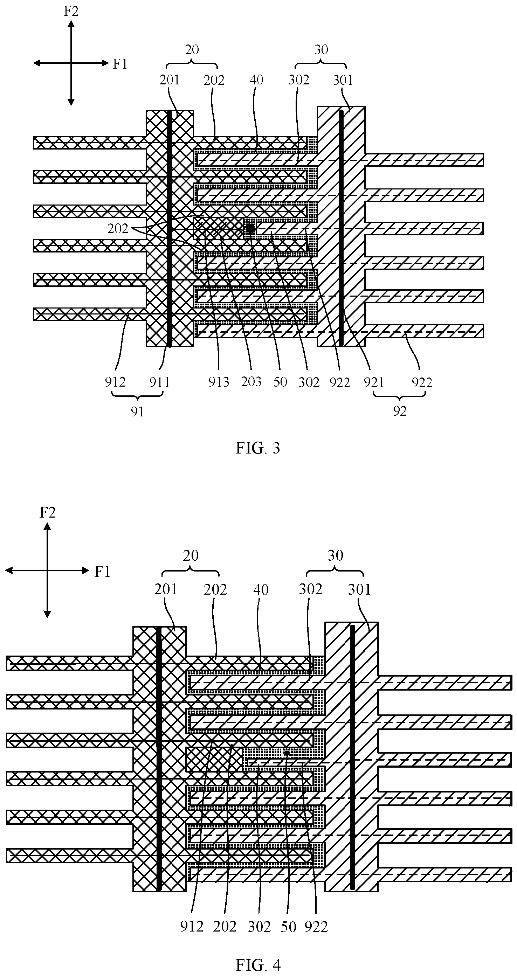

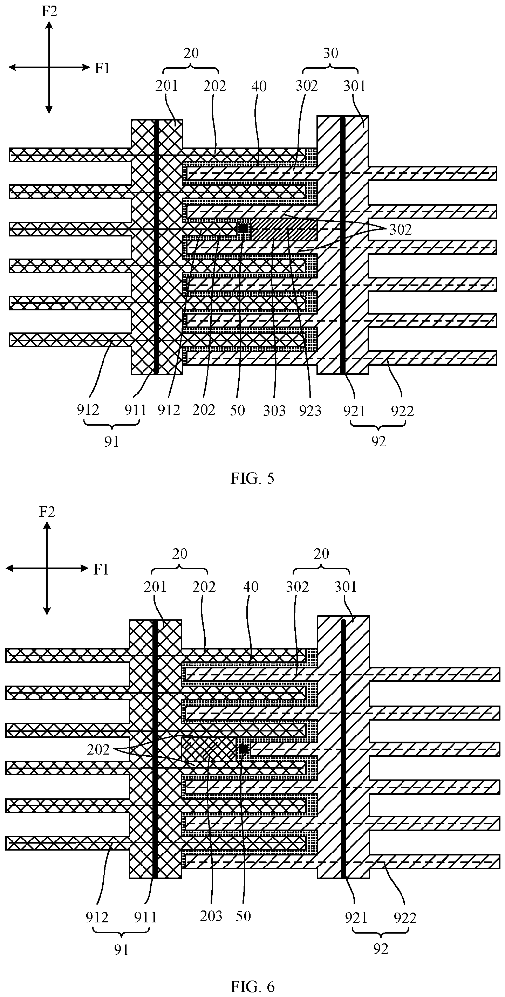

FIG. 1 is a schematic view showing a location of a marking structure in related art. FIG. 2A is a schematic structural view of a back-contact solar cell according to an embodiment of the present application. FIG. 2B is another schematic view of the back-contact solar cell according to the embodiment of the present application. FIG. 2C is another schematic view of the back-contact solar cell according to the embodiment of the present application. FIG. 3 is a schematic structural top view of a first emitter structure and a second emitter structure of the back-contact solar cell according to the embodiment of the present application. FIG. 4 is a schematic view showing a location of a marking structure in a back-contact solar cell according to another embodiment of the present application. FIG. 5 is a schematic view showing a location of a marking structure in a back-contact solar cell according to still another embodiment of the present application. FIG. 6 is a schematic structural view of a back-contact solar cell according to yet another embodiment of the present application.

In related art, referring to FIG. 1, a marking structure 101 (also commonly referred to as a marking point) can be a groove structure formed on a p-type doped layer 102 or an n-type doped layer 103. The groove structure formed on the n-type doped layer 103 is taken as an example for description herein. After a passivation layer is deposited on the p-type doped layer 102 or the n-type doped layer 103, electrode slurry is respectively printed on the p-type doped layer 102 and the n-type doped layer 103 to form electrodes. The marking structure 101 is located on the n-type doped layer 103, at a position corresponding to a finger electrode 104. The marking structure 101 can serve as a positioning reference in the process of forming the n-type doped layer 103 or the process of printing the electrode slurry. For positioning, the marking structure 101 is captured by an image capturing mechanism, such as a camera, from the top. However, such a marking structure 101 can easily be confused with an outer contour of the p-type doped layer 102 or the n-type doped layer, resulting in relatively low precision in positioning of the marking structure 101.

In addition, when the electrode slurry is printed on a location to overlap with the marking structure 101, the electrode slurry at the groove structure of the marking structure 101 can easily burn through the doped layer and come into contact with the substrate. When the substrate is n-type as an example for description, if the marking structure is formed on the p-type doped layer 102, the contact between the metal electrode formed on the p-type doped layer 102 and the n-type substrate will result in current leakage of the p-n junction, and if the marking structure 101 is formed on the n-type doped layer 103, the contact between the metal electrode formed on the n-type doped layer 103 and the n-type substrate will lead to increased carrier recombination. The two situations both can adversely affect the efficiency of the solar cell.

In the embodiments of the present application, the marking structure is an isolated island structure disposed in an insulative isolating groove, which can effectively improve the positioning precision. In addition, since the metal slurry is not printed in the insulative isolating groove, the current leakage and carrier recombination issues can also be effectively avoided, thereby improving the efficiency of the solar cell.

Referring to FIG. 2A and 2B, an embodiment of the present application provides a back-contact solar cell 100, which includes a substrate 10, a first emitter structure 20, a second emitter structure 30, and a marking structure 50.

The first emitter structure 20 is disposed on a first surface F of the substrate 10. The second emitter structure 30 is disposed on the first surface F of the substrate 10 and spaced from the second emitter structure 30. The doping type of the first emitter structure 20 is opposite to the doping type of the second emitter structure 30. Referring to FIG. 3, in some embodiments, the back-contact solar cell 100 includes a plurality of first emitter structures 20 and a plurality of second emitter structures 30 disposed on the first surface F, and alternately disposed and spaced apart from each other in a first preset direction F1. An insulative isolating groove 40 is defined between a first emitter structure 20 and a second emitter structure 30 that are adjacent to each other. In FIG. 2A, the position and range of the insulative isolating groove 40 is outlined by a dash-dotted line box. The marking structure 50 is disposed in the insulative isolating groove 40, and is spaced apart from both the first emitter structure 20 and the second emitter structure 30. FIG. 2A can be seen as an enlarged partial view of FIG. 2B, specifically showing the marking structure 50.

It should be understood that, the insulative isolating groove 40 is defined between a first emitter structure 20 and a second emitter structure 30 that are adjacent to each other. In some embodiments, the first emitter structure 20 and the second emitter structure 30 form the sidewalls of the insulative isolating groove 40. The marking structure 50 is disposed in the insulative isolating groove 40, and is spaced apart from both the first emitter structure 20 and the second emitter structure 30, which means that the marking structure 50 is spaced apart from the sidewalls of the insulative isolating groove 40. As a result, the marking structure 50 becomes an isolated island structure disposed in the insulative isolating groove 40. Thus, compared with the related art, where the marking structure 101 is formed on the p-type doped layer or the n-type doped layer, rendering easy confusion between the outer contours of the marking structure 101 and the p-type or n-type doped layer 102, 103, the marking structure 50 in the present application avoids confusion with the first emitter structure 20 and/or the second emitter structure 30. During the positioning process, the marking structure 50 can be easily captured by a camera and recognized, thereby ensuring a relatively high positioning precision, and further improving the yield of production of back-contact solar cells.

In addition, as described above, in the related art, the electrode slurry at the marking structure 101 can easily burn through the doped layer and come into contact with the substrate, resulting in current leakage of the p-n junction or increased carrier recombination, both of which adversely affect the efficiency of the solar cell.

In the embodiments of the present application, the island shaped marking structure 50 is disposed in the insulative isolating groove 40. When the first electrode 91 is formed on the first emitter structure 20 or the second electrode 92 is formed on the second emitter structure 30, the metal slurry of the first electrode 91 or the second electrode 92 cannot easily enter the insulative isolating groove 40, avoiding the issue of current leakage or carrier recombination increasing in the related art. Therefore, the efficiency of the back-contact solar cell 100 according to the embodiments of the present application can be further improved compared with the related art.

In the embodiments of the present application, the substrate 10 can further include a second surface S disposed opposite to the first surface F, and a side surface C adjacent to and connected with both the first surface F and the second surface S. For convenience of description, the first surface F is defined to include a first region Y, a second region E, and an isolating region G. Referring to FIG. 2A and FIG. 3, the first region Y and the second region E are alternately arranged in the first preset direction F1, and the isolating region G is located between the first region Y and the second region E that are adjacent to each other, thereby isolating the first region Y from the second region E. In addition, the isolating region G is divided to include two parts: a marking region B and a target region T. The target region T surrounds the marking region B, isolating the marking region B from the surrounding first region Y and second region E in space.

It should be noted that each of the first emitter structure 20 and the second emitter structure 30 includes a doped layer, and the doping type of the first emitter structure 20 is opposite to that of the second emitter structure 30, which means that the doping type of the doping element in the doped layer of the first emitter structure 20 is opposite to the doping type of the doping element in the doped layer of the second emitter structure 30. For example, in some embodiments, the doped layer in the first emitter structure 20 is p-type, and the doped layer in the second emitter structure 30 is n-type. In some other embodiments, the doped layer in the first emitter structure 20 is n-type, and the doped layer in the second emitter structure 30 is p-type. In the embodiments of the present application, the doped layer in the first emitter structure 20 is p-type, and the doped layer in the second emitter structure 30 is n-type, as an example for description. The case where the doped layer in the first emitter structure 20 is n-type and the doped layer in the second emitter structure 30 is p-type is similar, and will not be repeatedly described herein.

The plurality of first emitter structures 20 are disposed on the first surface F of the substrate 10, and the plurality of second emitter structures 30 are also disposed on the first surface F of the substrate 10. For example, the plurality of first emitter structures 20 can be respectively disposed in a plurality of first regions Y of the first surface F of the substrate 10, and the plurality of second emitter structures 30 can be respectively disposed in a plurality of second regions E of the first surface F of the substrate 10. Herein, the first emitter structure 20 can cover the entire first region Y, and the second emitter structure 30 can cover the entire second region E. In other words, the first region Y is defined as a corresponding first surface region covered with a first emitter structure 20, and the second region E is defined as a corresponding first surface region covered with a second emitter structure 30. It can be understood that, for the situation where the back-contact solar cell 100 includes a plurality of first emitter structures 20 and a plurality of second emitter structures 30, the quantity of the insulative isolating groove 40 can be plural, being a plurality of insulative isolating grooves 40, which are respectively disposed between the first emitter structures 20 and the second emitter structures 30 that are adjacent to each other. However, independent from the quantities of the first emitter structures 20, the second emitter structures 30, and the insulative isolating grooves 40, the quantity of the marking structure 50 can be only one or plural. The marking structure 50 can be disposed in a local area of an insulative isolating groove 40. For the plurality of marking structures 50, the marking structures 50 can be disposed in the same insulative isolating groove 40, or respectively disposed in different insulative isolating grooves 40.

In some embodiments, as shown in FIG. 3, the plurality of first emitter structures 20 and the plurality of second emitter structures 30 are alternately disposed and spaced apart from each other in the first preset direction F1, and parts of the adjacent first and second emitter structures 20 and 30 can be interdigitated with each other. Specifically, adjacent digit structures of the first and second emitter structures 20 and 30 can be alternately disposed and spaced apart from each other in a second preset direction F2, and the insulative isolating groove 40 can be disposed between the adjacent digit structures of first and second emitter structures 20 and 30. Corresponding to the interdigitated structure, portions of the first region Y and portions of the second region E can be alternately arranged and spaced apart from each other in the second preset direction F2, and the isolating region G can be disposed between the portions of the first region Y and portions of the second region E. The first preset direction F1 and the second preset direction F2 intersect with each other and are both perpendicular to a thickness direction of the solar cell 100. In some embodiments, the first preset direction F1 is perpendicular to the second preset direction F2.

The marking structure 50 is locally disposed in the insulative isolating groove 40 and is spaced apart from both the first emitter structure 20 and the second emitter structure 30, which means that when top viewed from the first surface F of the back-contact solar cell 100, there is a gap between the marking structure 50 and the first emitter structure 20, and between the marking structure 50 and the second emitter structure 30, and thus the marking structure 50 can be captured easily.

In some embodiments of the present application, referring to FIGs. 2A and 2C, a bottom of the insulative isolating groove 40 includes a first portion 401 and a second portion 402. The first portion 401 extends to the first surface F in the thickness direction of the substrate 10. The second portion 402 protrudes from the first surface F towards a direction away from the substrate 10 along the thickness direction of the substrate 10. That is, the second portion 402 defines a protruding structure that protrudes relative to the first portion 401, and thus the second portion 402 forms the marking structure 50. As such, in the insulative isolating groove 40, the layer thickness at the position of the marking structure 50 (i.e., the second portion 402) is greater than the layer thickness at the surrounding region (i.e., first portion 401) around the marking structure 50 as viewed in the thickness direction of the substrate 10, which makes it easier to distinguish the marking structure 50 from the surrounding region.

In some embodiments of the present application, referring to FIGs. 2A and 2B, the isolating region G is defined as a region corresponding to the insulative isolating groove 40 on the first surface F. In other words, the region where the insulative isolating groove 40 is located is named as the isolating region G. The reflectivity of the surface of the marking structure 50 away from the substrate 10 is different from the reflectivity of the surface of the first portion 401. In the isolating region G, the marking region B is defined as the region corresponding to the island shaped marking structure 50, and the target region T is defined as the region corresponding to rest of the insulative isolating groove 40 not occupied by the island shaped marking structure 50. As the marking structure 50 corresponds to the marking region B, and the rest part of the groove 40 corresponds to the target region T, the reflectivity of the surface of the marking structure 50 away from the substrate 10 is different from the reflectivity of the surface of the target region T. As such, in the image captured by a camera, there is a significant difference between the surface of the marking structure 50 and the surface of the surrounding target region T due to the different reflectivity, which facilitates an accurate positioning.

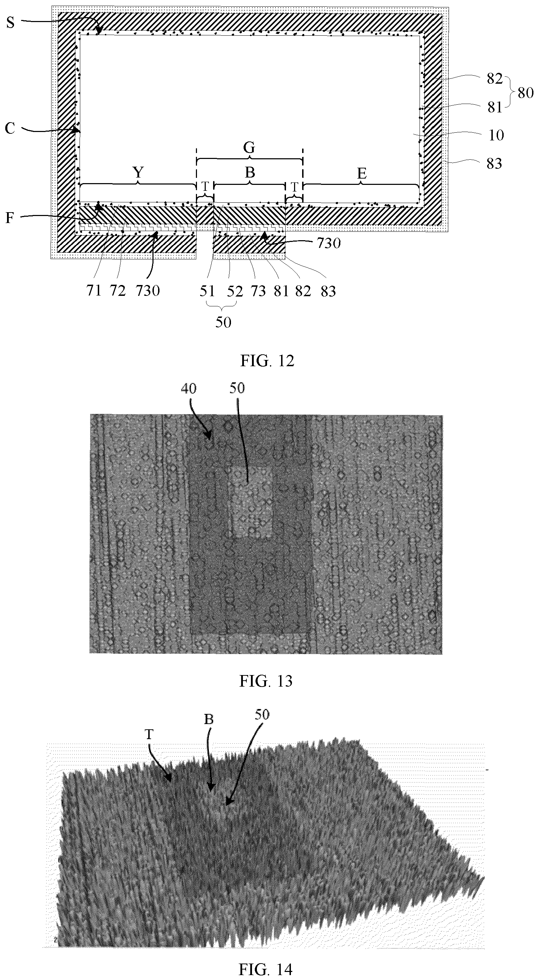

In the embodiments of the present application, the reflectivity of the surface of the marking structure 50 away from the substrate 10 can be greater than the reflectivity of the surface of the first portion 401 (i.e., the target region T). As such, referring to FIG. 13, FIG. 14, FIG. 17, and FIG. 18, in the captured images, the brightness at the position of the marking structure 50 is higher than the brightness of the surrounding region. Further, an average roughness of the surface of the marking structure 50 away from the substrate 10 can be less than an average roughness of the surface of the first portion 401 (i.e., the target region T), which makes the reflectivity of the surface of the marking structure 50 away from the substrate 10 higher than the reflectivity of the surface of the first portion 401 (i.e., the target region T).

In some embodiments, referring to FIGs. 2A and 2C, the surface of the marking structure 50 away from the substrate 10 can be a polished surface, and at least a part of the surface of the first portion 401 is formed with a textured surface structure 41. For example, the entire target region T can be formed with the textured surface structure 41, or only a part of the target region T is formed with the textured surface structure 41. In addition, it can be understood that, when the top view of the marking structure 50 is a solid figure, the first portion 401 can be located around the marking structure 50. When the top view of the marking structure 50 is a hollow figure, such as an annular figure, a part of the first portion 401 can be located around the marking structure 50, and another part of the first portion 401 can be surrounded by the marking structure 50.

In the embodiments of the present application, the marking structure 50 can at least include a doped layer that is substantially the same as the doped layer in the first emitter structure 20, e.g., in composition and/or thickness of the doped layers. Alternatively, the marking structure 50 can at least include a doped layer that is substantially the same as the doped layer in the second emitter structure 20, e.g., in composition and/or thickness of the doped layers. In this way, the marking structure 50 can be formed simultaneously with the first emitter structure 20 or the second emitter structure 30 in a same manufacturing step, thereby reducing the cost. The same composition herein can refer to the same bulk material and/or dopant and/or the same ratio between the bulk material and dopant in the doped layers.

In some embodiments, the layer structure of the marking structure 50 is the same as the layer structure of the first emitter structure 20, and the thickness of the marking structure 50 can be the same as the thickness of the first emitter structure 20. Alternatively, the layer structure of the marking structure 50 is the same as the layer structure of the second emitter structure 30, and the thickness of the marking structure 50 can be the same as the thickness of the second emitter structure 30.

In the embodiments of the present application, as described above, each of the first emitter structure 20 and the second emitter structure 30 can include a doped layer. In some embodiments, referring to FIGs. 2A and 2B, the first emitter structure 20 includes a first tunneling oxide layer 21 and a first doped polysilicon layer 22, which are stacked on the first surface F.

The marking structure 50 can include a first layer 51 and a second layer 52, which are stacked on the first surface F. The first layer 51 and the first tunneling oxide layer 21 can be made of a same material. The second layer 52 and the first doped polysilicon layer 22 can be made of a same material.

Further, the second emitter structure 30 can include a second tunneling oxide layer 31 and a second doped polysilicon layer 32, which are stacked on the first surface F. The doping type of the second doped polysilicon layer 32 is opposite to that of the first doped polysilicon layer 22. The materials of the first tunneling oxide layer 21 and the second tunneling oxide layer 31 can be the same or different. Except the opposite doping types, the materials of the first doped polysilicon layer 22 and the second doped polysilicon layer 32 can be the same or different. In some embodiments, the first layer 51 and the second tunneling oxide layer 31 can be made of a same material. The second layer 52 and the second doped polysilicon layer 32 can be made of a same material.

In some other embodiments, the layer structure of the marking structure 50 can be different from the layer structure of the first emitter structure 20, and can be different from the layer structure of the second emitter structure 30.

In the embodiments of the present application, the back-contact solar cell 100 can further include a first passivation layer 61 disposed on surfaces of the first emitter structure 20 and the second emitter structure 30 away from the substrate 10, and also covers the marking structure 50, e.g., covers the second layer 52 of the marking structure 50. In some embodiments, the first passivation layer 61 covers the entire first surface F of the substrate 10.

Herein, the first passivation layer 61 can be a single film or multiple films, made of a material selected from silicon nitride, aluminum oxide, titanium oxide, silicon oxide, or silicon oxynitride, or any combinations thereof. The first passivation layer 61 passivates the first surface F (e.g., the back surface) of the back-contact solar cell 100. In some embodiments, the first passivation layer 61 can also function as an antireflection layer.

Further, the back-contact solar cell 100 can include a second passivation layer 62, which is stacked on the second surface S of the substrate 10. The second passivation layer 62 includes a passivation layer 621 and an anti-reflection layer 622, which are stacked on the second surface S in sequence. The passivation layer 621 can be a single film or multiple films, made of a material selected from silicon nitride, aluminum oxide, titanium oxide, silicon oxide, silicon oxynitride, or any combinations thereof. The anti-reflection layer 622 can be a single film or multiple films, made of a material selected from silicon nitride, silicon oxynitride, or a combination thereof.

In the embodiments of the present application, in the top view, the surface of the marking structure 50 away from the substrate 10 can be in a circular, annular, or polygonal shape. Alternatively, the surface of the marking structure away from the substrate 10 can have a shape including at least two intersecting strips, e.g., a cross. The surface of the marking structure 50 away from the substrate 10 is not limited to the above shapes, and can be in other shapes.

In an embodiment of the present application, when the surface of the marking structure 50 away from the substrate 10 has a polygonal shape, an edge of the polygonal shape has a length in a range from 50 µm to 950 µm. In this way, the marking structure 50 can maintain a sufficient distance from the adjacent first emitter structure 20 and second emitter structure 30 to facilitate capturing by a camera.

In an embodiment of the present application, referring to FIG. 3, a distance between the marking structure 50 and the first emitter structure 20 is greater than 20 µm, and a distance between the marking structure 50 and the second emitter structure 30 is greater than 20 µm. For example, in the schematic top view of the back-contact solar cell 100 as viewed from the first surface F shown in FIG. 3, the distance between the marking structure 50 and each side wall of the surrounding insulative isolating groove 40 is greater than 20 µm.

In the embodiments of the present application, the quantity of the marking structure 50 can be plural, and the plurality of marking structures 50 are configured to locate the geometric center of the substrate 10. For example, the number of the marking structures 50 can be four, and the four marking structures can be disposed symmetrically relative to the geometric center of the substrate 10. Alternatively, the number of the marking structures 50 can be two, three, or more.

In an embodiment of the present application, still referring to FIG. 2C, a first inward diffusion layer 205 and a second inward diffusion layer 304 are further formed in the substrate 10 based on the structure shown in FIG. 2A. The other portions of the back-contact solar cell 100 shown in FIG. 2C are the same as those shown in FIG. 2A, and will not be described repeatedly herein.

Exemplarily, the first inward diffusion layer 205 and the second inward diffusion layer 304 extend from the first surface F of the substrate 10. The doping type of the doping element in the first inward diffusion layer 205 is the same as that of the doping element in the first emitter structure 20, and the doping type of the doping element in the second inward diffusion layer 304 is the same as that of the doping element in the second emitter structure 30. For example, the first inward diffusion layer 205 can be formed by diffusing the doping element into the substrate 10 by a certain depth during the formation of the doped layer of the first emitter structure 20 and the second layer 52 of the marking structure 50. The second inward diffusion layer 304 can be formed by diffusing the doping element into the substrate 10 by a certain depth during the formation of the doped layer of the second emitter structure 30.

The first inward diffusion layer 205 is located at a position corresponding to the first emitter structure 20 and the marking structure 50. The second inward diffusion layer 304 is located at a position corresponding to the second emitter structure 30.

Further, a thickness of the first inward diffusion layer 205 can be greater than a thickness of the second inward diffusion layer 304. In some embodiments, the thickness of the first inward diffusion layer 205 is in a range from 50 nm to 200 nm, and the thickness of the second inward diffusion layer 304 is in a range from 20 nm to 100 nm.

In the embodiments of the present application, the back-contact solar cell 100 can further include one or more first electrodes 91 and one or more second electrodes 92. The quantities of the first electrodes 91 and the second electrodes 92 can be respectively equal to the quantities of the first emitter structures 20 and the second emitter structures 30. The the first electrodes 91 and the second electrodes 92 can be respectively arranged in one-to-one correspondence with the first emitter structures 20 and the second emitter structures 30. Each first electrode 91 is disposed on a side of a corresponding first emitter structure 20 away from the substrate 10, and is electrically connected to the doped layer of the corresponding first emitter structure 20. Each second electrode 92 is disposed on a side of a corresponding second emitter structure 30 away from the substrate 10, and is electrically connected to the doped layer of the corresponding second emitter structure 30.

In the embodiments of the present application, the marking structure 50 is configured to serve as a positioning reference for the positioning of the second emitter structure 30 during the formation thereof. Further, the marking structure 50 can also be configured to serve as a positioning reference during the formation of the first electrode 91 and the second electrode 92.

In some embodiments, referring to FIG. 3, the first emitter structure 20 includes a first main structure 201 and one or more first digit structures 202 spaced from each other and extending from the first main structure 201. The second emitter structure 30 includes a second main structure 301 and one or more second digit structures 302 spaced from each other and extending from the second main structure 301. The first digit structures 202 can extend from a same single side of the first main structure 201, or respectively extend from both sides of the first main structure 201. The second emitter structures 30 can extend from a same single side of the second main structure 301, or respectively extend from both sides of the second main structure 301.

The first main structure 201 of the first emitter structure 20 and the second main structure 301 of the second emitter structure 30 are alternately disposed and spaced apart from each other in the first preset direction F1. Each first main structure 201 can be connected to at least two first digit structures 202, which are spaced apart from each other in the second preset direction F2. Each second main structure 301 can be connected to at least two second digit structures 302, which are spaced apart from each other in the second preset direction F2. The first preset direction F1 and the second preset direction F2 intersect with each other, and are both perpendicular to the thickness direction of the back-contact solar cell 100. The first main structure 201 and the second main structure 301 are respectively located corresponding to a busbar of the first electrode 91 and a busbar of the second electrode 92. The first main structure 201 and the second main structure 301 can be strip shaped structures with a length direction being in the second preset direction F2. The first digit structures 202 and the second digit structures 202 are respectively located corresponding to finger electrodes of the first electrode 91 and finger electrodes of the second electrode 92. The first digit structures 202 and the second digit structures 202 can be strip shaped structures with a length direction being in the first preset direction F1, and can be narrower than the first main structure 201 and the second main structure 301.

The first digit structures 202 and the second digit structures 302 that are located between adjacent first and second main structures 201 and 301 are interdigitated with each other. The marking structure 50 can be located in a region where the interdigitated first and second digit structures 202 and 302, i.e., located in an interdigitated region of the first digit structures 202 and the second digit structures 302.

Referring to FIG. 3, the first digit structures 202 and the second digit structures 302 located between adjacent first and second main structures 201 and 301 that are interdigitated with each other, which means that the first digit structures 202 and the second digit structures 302 located between the adjacent first and second main structures 201 and 301 have an interdigitated region. For example, in the first preset direction F1, each first digit structure 202 on the right side of the first main structure 201 extend into a gap between adjacent two second digit structures 302 on the left side of the second main structure 301. The interdigitated region refers to a region in which the first digit structure 202 and the second digit structure 302 are interdigitated with each other.

In the embodiments of the present application, the first digit structures 202 and the second digit structures 302 located between any adjacent first and second main structures 201 and 301 can be alternately disposed in the second preset direction F2.

In some embodiments, the marking structure 50 can be located at the end of a first digit structure 202 or located at the end of a second digit structure 302, respectively as shown in FIGs. 3 and 5. Alternatively, the marking structure 50 can be located between a first digit structure 202 and a second digit structure 302 that are adjacent to each other in the second preset direction F2, as shown in FIG. 4.

Specifically, referring to FIG. 3, in some embodiments, the marking structure 50 is located at the end of a second digit structure 302 away from the corresponding second main structure 301 in the first preset direction F1. The length of the specific second digit structure 302 where the marking structure 50 locates can be substantially equal to the length of the other second digit structures 302 between the same adjacent first and second main structures 201 and 301, such that the marking structure 50 can be next to the first main structure 201. Alternatively, the specific second digit structure 302 where the marking structure 50 locates can be shorter than the other second digit structures 302, such that the marking structure 50 can be spaced from both of the adjacent first and second main structures 201 and 301. Specifically, the distance between the marking structure 50 and the adjacent first main structure 201 can be equal to the distance between the marking structure 50 and the adjacent second main structure 301.

Further, in the latter embodiment as described, the first emitter structure 20 can further include a first connecting structure 203 disposed between the marking structure 50 and the adjacent first main structure 201 in the first preset direction F1, and disposed between two adjacent first digit structures 202 in the second preset direction F2. The two adjacent first digit structures 202 can be connected to each other via the first connecting structure 203 in the second present direction F2, e.g., the two adjacent first digit structures 202 can be in contact with the first connecting structure 203. The marking structure 50 is located between the second digit structure 302 and the corresponding first connecting structure 203 in the first preset direction F1, and the second digit structure 302 is inserted between the two adjacent first digit structures 202 in the second preset direction F2. In this way, in the first preset direction F1, the first emitter structure 20 and the second emitter structure 30 are respectively located at both sides of the marking structure 50, thereby sufficiently collecting electric current to increase the efficiency of carrier collection.

Referring to FIG. 5, in some other embodiments, the marking structure 50 is located at the end of a first digit structure 202 away from a corresponding first main structure 201 in the first preset direction. The length of the specific first digit structure 202 where the marking structure 50 locates can be substantially equal to the length of the other first digit structures 202 between the same adjacent first and second main structures 201 and 301, such that the marking structure 50 can be next to the second main structure 301. Alternatively, the specific first digit structure 202 where the marking structure 50 locates can be shorter than the other first digit structures 202, such that the marking structure 50 can be spaced from both of the adjacent first and second main structures 201 and 301. Specifically, the distance between the marking structure 50 and the adjacent first main structure 201 can be equal to the distance between the marking structure 50 and the adjacent second main structure 301.

Further, in the latter embodiment as described, the second emitter structure 30 can further include a second connecting structure 303 disposed between the marking structure 50 and the adjacent first main structure 201 in the first preset direction F1, and disposed between two adjacent first digit structures 202 in the second preset direction F2. The two adjacent second digit structures 302 can be connected to each other via the second connecting structure 303 in the second present direction F2, e.g., the two adjacent first digit structures 202 can be in contact with the first connecting structure 203. The marking structure 50 is located between the first digit structure 202 and the corresponding second connecting structure 303 in the first preset direction F1, and the first digit structure 202 is inserted between the two adjacent second digit structures 302 in the second preset direction F2. In this way, in the first preset direction F1, the first emitter structure 20 and the second emitter structure 30 are respectively located at both sides of the marking structure 50, thereby sufficiently collecting electric current to increase the efficiency of carrier collection.

Referring to FIG. 4, in yet some other embodiments, the marking structure 50 is located between a first digit structure 202 and a second digit structure 302 adjacent to each other in the second preset direction F2. In the second preset direction F2, the first digit structure 202 can be located at one side the marking structure 50, and the second digit structure 302 can be located at the other side of the marking structure 50. The first digit structure 202 and/or the second digit structure 302 which are/is located at the two sides of the marking structure 50 in the second preset direction F2 can be narrower than the other first and second digit structures 202 and 203, such that the portion of the insulative isolating groove 40 therebetween can be wider than the other portions of the insulative isolating groove 40, allowing the marking structure 50 to be sufficiently spaced from the adjacent first and second digit structures 202 and 203. The first digit structure 202 and/or the second digit structure 302 which are/is located at the two sides of the marking structure 50 in the second preset direction F2 can have the same length as, or shorter than, the other first and second digit structures 202 and 203. Similar to the above-described embodiments, the first emitter structure 20 can further include a first connecting structure 203, and/or the second emitter structure 30 can further include a second connecting structure 303. The structures, locations, etc. of the first connecting structure 203 and/or the second connecting structure 303 can be similar to those described in the above embodiments, and will not be repeatedly described herein.

In the embodiments of the present application, referring back to FIG. 3, each first electrode 91 can include a first busbar 911 and one or a plurality of first finger electrodes 912 electrically connected to the first busbar 911. Each second electrode 92 can include a second busbar 921 and one or a plurality of second finger electrodes 922 electrically connected to the second busbar 921. The first finger electrodes 912 can be spaced from each other, and can extend from a same single side of the first busbar 911, or respectively extend from both sides of the first busbar 911. The second finger electrodes 922 can be spaced from each other, and can extend from a same single side of the second busbar 921, or respectively extend from both sides of the second busbar 921.

The first busbar 911 and the first finger electrodes 912 are correspondingly disposed on the first main structure 201 and the first digit structures 202, respectively. The second busbar 921 and the second finger electrodes 922 are correspondingly disposed on the second main structure 301 and the second digit structures 302, respectively. For example, the first busbar 911 is disposed on the side of the first main structure 201 away from the substrate 10, and the first finger electrode 912 is disposed on the side of the first digit structure 202 away from the substrate 10. The second busbar 921 is disposed on the side of the second main structure 301 away from the substrate 10, and the second finger electrode 922 is disposed on the side of the second digit structure 302 away from the substrate 10.

The plurality of first busbars 911 and the plurality of second busbars 921, respectively corresponding to the plurality of first main structures 201 and the plurality of first main structures 301, are also alternately disposed and spaced apart from each other in the first preset direction F1. Each first busbar 911 can be connected to at least two first finger electrodes 912 spaced apart from each other in the second preset direction F2. Each second busbar 921 can be connected to at least two second finger electrodes 922 spaced apart from each other in the second preset direction F2. The first finger electrodes 912 and the second finger electrodes 922 located between adjacent first and second busbars 911 and 921 are interdigitated with each other. The marking structure 50 is located in a region where the first finger electrodes 912 and the second finger electrodes 922 are interdigitated with each other, i.e., located in the interdigitated region of the first finger electrodes 912 and the second finger electrodes 922.

In some embodiments, the first finger electrodes 912 and the second finger electrodes 922 located between any adjacent first and second busbar 911 and 921 can be alternately disposed along the second preset direction F2. Both the first finger electrodes 912 and the second finger electrodes 922 can extend in the first preset direction F1.

The first busbar 911, the first finger electrodes 912, the second busbar 921, and the second finger electrodes 912 can have features that are corresponding to the first main structure 201, the first digit structures 202, the second main structure 301, and the second digit structures 302, respectively.

Referring to FIG. 3, in some embodiments, the marking structure 50 is located at the end of the second finger electrode 922 away from the corresponding second busbar 921 in the first preset direction F1. The distance between the center of the marking structure 50 and the second busbar 921 can be greater than or equal to the distance between the center of the marking structure 50 and the first busbar 921. The length of the second finger electrode 922 at the position corresponding to the marking structure 50 can be shortened due to the arrangement of the marking structure 50, thus weakening the capability to collect n-type carriers at this position. The distance between the center of the marking structure 50 and the second busbar 921 is greater than or equal to the distance between the center of the marking structure 50 and the first busbar 911, which can minimize the shortening of the length of the second finger electrode 922 caused by the arrangement of the marking structure 50.

In some embodiments, the first electrode 91 further includes a first connecting line 913. The first connecting line 913 is located between two adjacent first finger electrodes 912 and connected to the first busbar 911. The marking structure 50 is located between a second finger electrode 922 and the first connecting line 913 in the first preset direction F1, and the second finger electrode 922 is inserted between the two adjacent first finger electrodes 912 in the second preset direction F2. The first connecting line 913 is disposed on the first connecting structure 203.

Referring to FIG. 5, in some other embodiments, the marking structure 50 is located at the end of a first finger electrode 912 away from a corresponding first busbar 911 in the first preset direction F1. The distance between the center of the marking structure 50 and the first busbar 911 can be greater than or equal to the distance between the center of the marking structure 50 and the second busbar 921. Similarly, the length of the first finger electrode 912 at the position corresponding to the marking structure 50 can be shortened due to the arrangement of the marking structure 50, thus weakening the capability to collect p-type carriers at this position. The distance between the center of the marking structure 50 and the first busbar 911 is greater than or equal to the distance between the center of the marking structure 50 and the second busbar 921, which can minimize the shortening of the length of the first finger electrode 921 caused by the arrangement of the marking structure 50.

In some other embodiments, the second electrode 92 further includes a second connecting line 923. The second connecting line 923 is located between two adjacent second finger electrodes 922 and connected to the second busbar 921. The marking structure 50 is located between the first finger electrode 912 and the second connecting line 923 in the first preset direction F1, and the first finger electrode 912 is inserted between two adjacent second finger electrodes 922 in the second preset direction F2. The second connecting line 923 is disposed on the second connecting structure 303.

The marking structure 50 can be arranged as shown in FIGs. 3 and 5, where electrode lines for collecting carriers can be disposed on both sides of the marking structure 50, thereby sufficiently collecting electric current to increase the efficiency of carrier collection.

Referring to FIG. 4, in yet some other embodiments, the marking structure 50 is located between a first finger electrode 912 and a second finger electrode 922 adjacent to each other in the second preset direction F2. In the second preset direction F2, the first finger electrode 912 can be located at one side of the marking structure 50, and the second finger electrode 922 can be located at the other side of the marking structure 50.

In addition, the first connecting line 913 is optional, which can be disposed on the first connecting structure 203 as shown in FIG. 3, or not formed as shown in FIG. 6. Similarly, the second connecting line 923 is optional, which can be disposed on the second connecting structure 303 as shown in FIG. 5, or not formed in the solar cell.

In addition, an embodiment of the present application further provides a method for preparing a back-contact solar cell, which can be used for preparing the back-contact solar cell 100 as described above. That is, the back-contact solar cell 100 according to the embodiments of the present application can be prepared by the following preparation method.

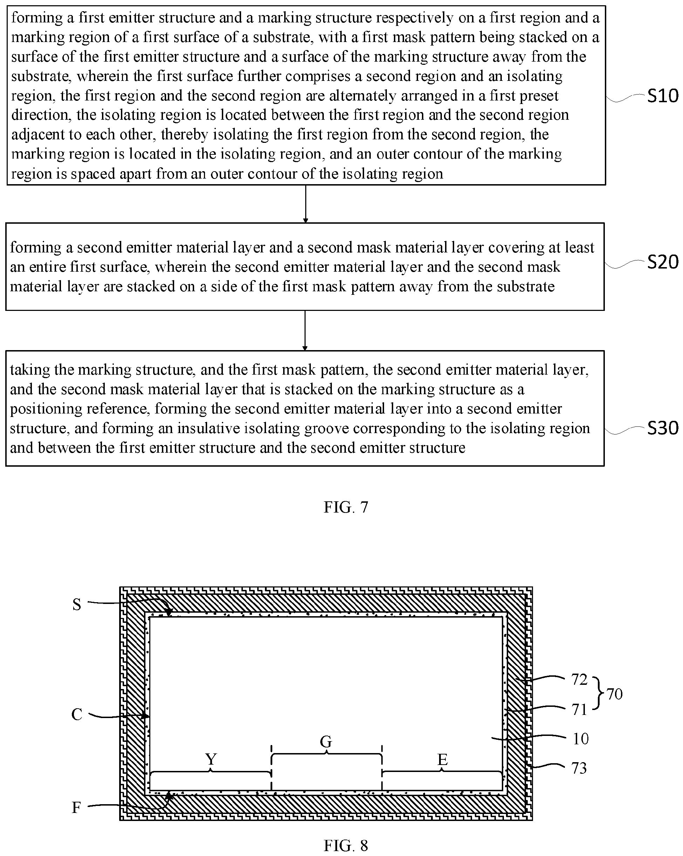

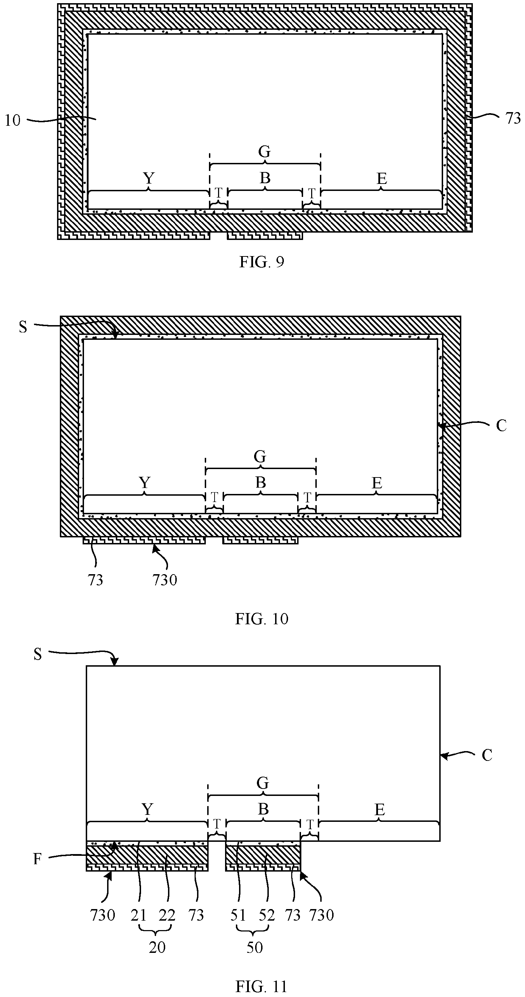

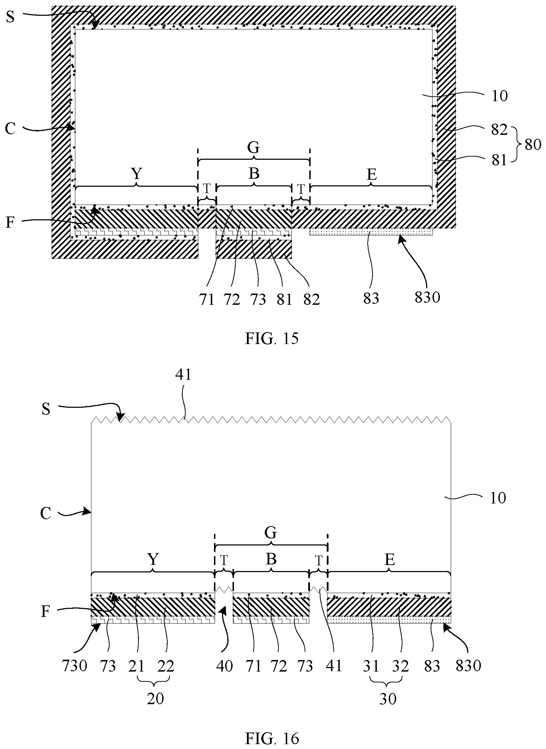

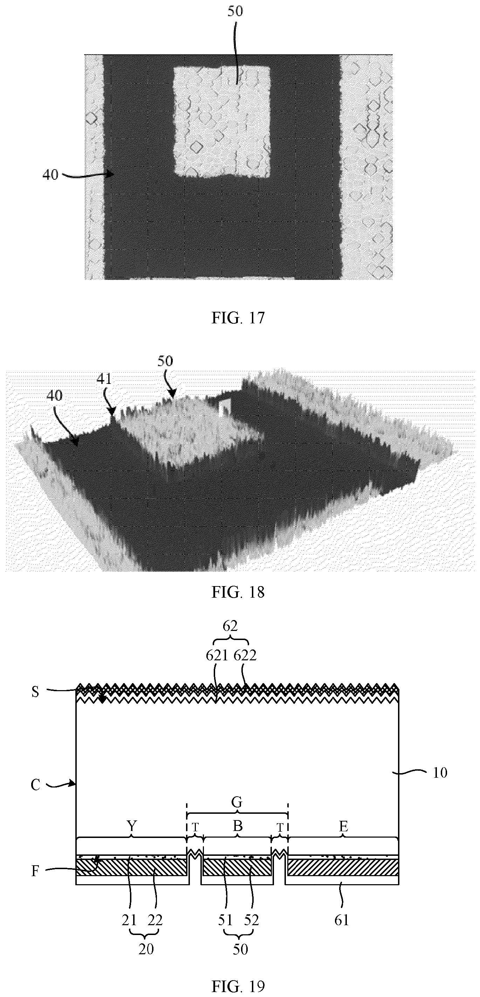

FIG. 7 shows a flow chart of a method for preparing a back-contact solar cell according to an embodiment of the present application. FIG. 8 is a schematic view of forming a first tunneling material layer, a first doped polysilicon material layer, and a first mask material layer in a method for preparing a back-contact solar cell according to an embodiment of the present application. FIG. 9 is a schematic view of patterning at a first surface of a substrate in a method for preparing a back-contact solar cell according to an embodiment of the present application. FIG. 10 is a schematic view of removing a first mask material layer from a side surface and a second surface in a method for preparing a back-contact solar cell according to an embodiment of the present application. FIG. 11 is a schematic view of a first emitter structure and a marking structure in a method for preparing a back-contact solar cell according to an embodiment of the present application. FIG. 12 is a schematic view of forming a second tunneling material layer, a second doped polysilicon material layer, and a second mask material layer in a method for preparing a back-contact solar cell according to an embodiment of the present application. FIG. 13 shows an optical image of a marking structure, after forming a second tunneling material layer, a second doped polysilicon material layer and a second mask material layer. FIG. 14 shows a three-dimensional structural optical image of the marking structure, after forming the second tunneling material layer, the second doped polysilicon material layer and the second mask material layer. FIG. 15 is a schematic view of forming a second mask pattern in a method for preparing a back-contact solar cell according to an embodiment of the present application. FIG. 16 is a schematic view of forming a second emitter structure in a method for preparing a back-contact solar cell according to an embodiment of the present application. FIG. 17 shows an optical image of a marking structure after forming a second emitter structure. FIG. 18 shows a three-dimensional structural optical image of the marking structure, after forming the second emitter structure. FIG. 19 is a schematic view of forming a first passivation layer and a second passivation layer in a method for preparing a back-contact solar cell according to an embodiment of the present application. The images shown in FIGs. 13, 14, 17 and 18 are obtained using an optical microscope, such as a 3D microscope.

Referring to FIGs. 7 to 19, the method for preparing the back-contact solar cell according to the embodiment of the present application includes:
S10: forming a first emitter structure 20 and a marking structure 50 respectively on a first region Y and a marking region B of a first surface F of a substrate 10, with a first mask pattern 730 being stacked on a surface of the first emitter structure 20 and a surface of the marking structure 50 away from the substrate 10, wherein the first surface F further includes a second region E and an isolating region G, the first region Y and the second region E are alternately arranged in a first preset direction F1, the isolating region G is located between the first region Y and the second region E adjacent to each other, thereby isolating the first region Y from the second region E, the marking region B is located in the isolating region G, and an outer contour of the marking region B is spaced apart from an outer contour of the isolating region G;
S20: forming a second emitter material layer 80 and a second mask material layer 83 covering at least the entire first surface F, wherein the second emitter material layer 80 and the second mask material layer 83 are stacked on a side of the first mask pattern 730 away from the substrate 10; and
S30: taking the marking structure 50, and the portion of the first mask pattern 730, the second emitter material layer 80, and the second mask material layer 83 that is stacked on the marking structure 50 as a positioning reference, forming the portion of the second emitter material layer 80 located in the second region E into a second emitter structure 30, and forming an insulative isolating groove 40 corresponding to the isolating region G and between the first emitter structure 20 and the second emitter structure 30.

On the first surface F of the substrate 10, by forming the first emitter structure 20 in the first region Y, forming the marking structure 50 in the marking region B, forming the second emitter structure 30 in the second region E, and forming the insulative isolating groove 40 corresponding to the isolating region G and between the first emitter structure 20 and the second emitter structure 30, the first emitter structure 20 can be formed in the first region Y, the second emitter structure 30 can be formed in the second region E, the marking structure 50 can be formed in the marking region B, and the insulative isolating groove 40 can be formed in the isolating region G. As the isolating region G is located between the adjacent first region Y and second region E to space the first region Y from the second region E, the marking region B is located in the isolating region G, and the outer contour of the marking region B is spaced from the outer contour of the isolating region G, therefore, the marking structure 50 can be disposed in the insulative isolating groove 40 and spaced from both the first emitter structure 20 and the second emitter structure 30 adjacent thereto. Thus, the marking structure 50 can be formed into an isolated island structure in the insulative isolating groove 40. The portion of the second emitter material layer 80 located in the second region E can be formed into the second emitter structure 30 by taking the marking structure 50, as well as the portion of the first mask pattern 730, the second emitter material layer 80, and the second mask material layer 83 stacked on the marking structure 50 as the positioning reference. As such, compared with the related art, where the marking structure is formed on the p-type doped layer or the n-type doped layer, rendering easy confusion between the outer contours of the marking structure and the p-type doped layer or the n-type doped layer, the positioning reference in the present application, i.e., the marking structure 50 as well as the first mask pattern 730, the second emitter material layer 80, and the second mask material layer 83 stacked on the marking structure 50, can avoid confusion with the first emitter structure 20 and/or the second emitter structure 30. During the positioning process, the positioning reference can be easily captured by a camera and recognized, thereby ensuring a relatively high positioning precision, and thus further improving the yield of production of the back-contact solar cells.

In addition, as described above, in the related art, the electrode slurry at the marking structure 101 can easily burns through the doped layer and come into contact with the substrate, resulting in current leakage of the p-n junction or increased carrier recombination. The two situations both can adversely affect the efficiency of the solar cell.

In the embodiments of the present application, the island shaped marking structure 50 is disposed in the insulative isolating groove 40. When the first electrode 91 is formed on the first emitter structure 20 or the second electrode 92 is formed on the second emitter structure 30, the metal slurry of the first electrode 91 or the second electrode 92 cannot easily enter the insulative isolating groove 40, avoiding the issue of current leakage or carrier recombination increasing in related art. Therefore, the efficiency of the back-contact solar cell 100 according to the embodiments of the present application can be further improved compared with the related art.

In S20, the second emitter material layer 80 and the second mask material layer 83 cover at least the entire first surface F, and thus are stacked on the side of the first mask pattern 730 away from the substrate 10, meaning that the second emitter material layer 80 and the second mask material layer 83 can cover not only the entire first surface F, but also the side surface C and the second surface S of the substrate 10.

In S10, by forming the first emitter structure 20 and the marking structure 50 on the first region Y and the marking region B of the first surface F of the substrate 10, respectively, the first emitter structure 20 can be formed on the first surface F and in the first region Y, the marking structure 50 can be formed on the first surface F and in the marking region B, while the remaining region of the first surface F is not covered with any layer. As such, in S20, when the second emitter material layer 80 and the second mask material layer 83 is formed to cover at least the entire first surface F are stacked on the side of the first mask pattern 730 away from the substrate10, the layers stacked in the marking region B of the first surface F include: the marking structure 50, the first mask pattern 730, the second emitter material layer 80, and the second mask material layer 83. In the isolating region G and besides the marking region B, the layers that are stacked in the target region T are the second emitter material layer 80 and the second mask material layer 83. Since the outer contour of the marking region B is spaced apart from the outer contour of the isolating region G, which means the target region T encloses the marking region B, the thickness of the layer stack in the marking region B is greater than the thickness of the layer stack in the surrounding target region T, facilitating image capture of the marking structure 50, thereby ensuring a relatively high positioning precision.

In some embodiments of the present application, in step S30, forming the second emitter structure 30 and the insulative isolating groove 40 specifically includes:
referring to FIG. 12, taking the marking structure 50, and the portion of the first mask pattern 730, the second emitter material layer 80, and the second mask material layer 83 that is stacked on the marking structure 50 as the positioning reference, removing the portion of the second mask material layer 83 covering the first region Y and the isolating region G;
referring to FIG. 15, further patterning the second mask material layer 83 to retain the portion of the second mask material layer 83 corresponding to the second region E to form a second mask pattern 830, where the patterning can be performed through, for example, a wet chemical method; and
referring to FIG. 16, etching the second emitter material layer 80 into the second emitter structure 30 covering the second region E through the second mask pattern 830 as a mask, which forms the insulative isolating groove 40 corresponding to the isolating region G and between the first emitter structure 20 and the second emitter structure 30.

In some embodiments, removing the portion of the second mask material layer 83 covering the first region Y and the isolating region G specifically includes:
with the layer stack composed by the marking structure 50, and the portion of the first mask pattern 730, the second emitter material layer 80, and the second mask material layer 83 stacked on the marking structure 50 captured as the positioning reference, removing the portion of the second mask material layer 83 covering the first region Y and the isolating region G through laser etching. As described above, since the layer stack in the marking region B is thicker than the layer stack in the surrounding target region T, the layer stack composed by the marking structure 50, and the portion of the first mask pattern 730, the second emitter material layer 80, and the second mask material layer 83 stacked on the marking structure 50 can be captured easily.

During forming the second emitter material layer 80 and the second mask material layer 83 through a deposition method, the second emitter material layer 80 and the second mask material layer 83 can also be formed on the second surface S and the side surface C of the substrate 10.

In some embodiments, further patterning the second mask material layer 83 to retain the portion of the second mask material layer 83 corresponding to the second region E to form the second mask pattern specifically includes:
removing the portion of the second mask material layer 83 covering the side surface C and the second surface S through washing with an acidic solution. After this step, in the second mask material layer 83, only the portion corresponding to the second region E is left while the rest portion is removed, thereby forming the second mask pattern 830.

In some embodiments, forming the second emitter structure 30 and the insulative isolating groove 40 specifically includes:
referring to FIGs. 15 and 16, wet etching the second emitter material layer 80 with an alkaline solution through the second mask pattern 830 as a mask to form the second emitter structure 30 and the insulative isolating groove 40. Under the protection of the second mask pattern 830 and the first mask pattern 730, the corresponding portion of the second emitter material layer 80 in the second region E and the corresponding portions of the first emitter structure 20 and the marking structure 50 respectively in the first region Y and the marking region B are not etched, while the rest portions of the second emitter material layer 80 including the portions in the target region T, the side surface C and the second surface S, and the portions on the first mask pattern 730 in the first region Y and the marking region B are removed.

In some embodiments, wet etching the second emitter material layer 80 with the alkaline solution through the second mask pattern 830 as a mask specifically includes:
removing the portions of the second emitter material layer 80 covering the first region Y and the isolating region G and texturing a surface of substrate 10 in the target region T into a textured surface structure 41 with the alkaline solution. As such, during the subsequent formation of the first electrode 91 and the second electrode, the marking structure 50 is more significantly different from the surrounding target region T in morphology, making the difference more significant in the captured image, thus improving the precision of the positioning.

In some embodiments of the present application, forming the first emitter structure 20 and the marking structure 50 specifically includes:
referring to FIG. 8, forming a first emitter material layer 70 and a first mask material layer 73 stacked on at least the first surface F of the substrate 10;
referring to FIGs. 9 and 10, patterning the first mask material layer 73 into the first mask pattern 730 covering the marking region B and the first region Y; and
etching the first emitter material layer 70 through the first mask pattern 730 as a mask to form the first emitter structure 20 and the marking structure 50.

Further, the first emitter material layer 70 and the first mask material layer 73 can also be formed on the second surface S and the side surface C of the substrate 10. Referring to FIGs. 9 and 10, patterning the first mask material layer 73 into the first mask pattern 730 specifically includes:
removing the portion of the first mask material layer 73 covering the second region E and the target region T through laser etching, and removing the portion of the first mask material layer 73 covering the side surface C and the second surface S through washing with an acidic solution.

In the related art, after a p-type doped material layer and a mask layer are deposited on a substrate, the n-type region and the isolating region can be laser etched to form a mask pattern covering the p-type region, and a preset local area in the n-type region can be then laser processed. After that, the substrate is wet etched to form the p-type doped layer in the p-type region and form the marking structure in the preset local area in the n-type region that has been subjected to multiple laser treatment steps. In contrast with the single step of laser etching on the n-type region and the isolating region, in the method of the related art, the laser processing on the preset local area needs to be carried out slowly and multiple times to ensure that the morphology of the marking structure is clear enough after the wet etching, which will increase the laser processing time and thus adversely affect the productivity.

In contrast, in the embodiments of the present application, the portion of the first mask material layer 73 covering the second region E and the target region T is removed by laser etching, and the portion of the first mask material layer 73 covering the side surface C and the second surface S is removed by washing with an acidic solution. In this way, the portions of the first mask material layer 73 in the marking region B and the first region Y can be retained to form the first mask pattern 730, and then the first emitter material layer 70 can be wet chemically etched through the first mask pattern 730 to form the marking structure 50. In this process, the laser is only used for etching the portion of the first mask material layer 73 in the second region E and the target region T, without special requirements such as being carried out slowly for multiple times, saving the time of laser processing, reducing the cost, and improving the production capacity.

In some embodiments, removing the portion of the first mask material layer 73 covering the target region T through laser etching includes:
scanning the isolating region G with a laser, including turning off the laser for a preset time when scanning reaches the marking region B, and turning on the laser when scanning reaches the target region T.

In some embodiments, forming the first emitter material layer 70 and the first mask material layer 73 stacked on at least the first surface F of the substrate 10 includes:
forming a first tunneling material layer 71 and a first doped polysilicon material layer 72 in sequence as the first emitter material layer 70 stacked on the surfaces of the substrate 10, and forming a first oxide material layer as a first mask material layer 73 on a surface of the first doped polysilicon material layer 72 away from the substrate 10. When the first doped polysilicon material layer 72 is p-type, the first oxide material layer can be borosilicate glass (BSG).

Similarly, referring to FIG. 12, in step S20, forming the second emitter material layer 80 and the second mask material layer 83 covering at least the entire first surface F and stacked on the side of the first mask pattern 730 away from the substrate 10 includes:
forming a second tunneling material layer 81 and a second doped polysilicon material layer 82 in sequence as the second emitter material layer 80 stacked on the surfaces of the substrate 10, and forming a second oxide material layer as the second mask material layer 83 on a surface of the second doped polysilicon material layer 82 away from the substrate 10. When the second doped polysilicon material layer 82 is n-type, the first oxide material layer can be phosphosilicate glass (PSG).

In some embodiments of the present application, referring to FIGs. 16 and 19, after forming the second emitter structure 30 and the insulative isolating groove 40 in step S30, the method further includes:
removing the first mask material layer 730 and the second mask material layer 830; and
forming a first passivation layer 61 on a side of the first emitter structure 20, the second emitter structure 30, and the marking structure 50 away from the substrate 10, wherein the first passivation layer 61 covers the entire first surface F.

In some embodiments, after forming the first passivation layer 61, the method further includes:
taking the marking structure 50 and the portion of the first passivation layer 61 that is stacked on the marking structure 50 as a positioning reference, forming a first electrode 91 and a second electrode 92 on the first passivation layer 61 corresponding to the first emitter structure 20 and the second emitter structure 30, respectively, wherein the first electrode 91 is electrically connected to the first emitter structure 20, and the second electrode 92 is electrically connected to the second emitter structure 30.

A specific example of the method for preparing a solar cell according to an embodiment of the present application is described below, and the method includes the following steps:
Step 1: Referring to FIG. 8, a substrate 10 is cleaned. The substrate 10 includes a first surface F and a second surface S opposite to each other, and further includes a side surface C adjacent to and between the first surface F and the second surface S. The first surface F includes a first region Y and a second region E alternately arranged in a first preset direction F1, and further includes an isolating region G located between the first region Y and the second region E.
Step 2: Referring to FIG. 8, an ultra-thin tunneling layer with a thickness ranged from 1 nm to 5 nm is formed on the entire first surface F of the substrate 10 and serves as a first tunneling material layer 71. A first doped polysilicon material layer 72 with a thickness ranged from 100 nm to 500 nm is deposited on the surface of the first tunneling material layer 71 away from the substrate 10. The first tunneling material layer 71 and the first doped polysilicon material layer 72 are collectively referred to as a first material layer 70. A first mask material layer 73 is then formed on the surface of the first doped polysilicon material layer 72 away from the substrate 10. During the above steps, the first tunneling material layer 71, the first doped polysilicon material layer 72, and the first mask material layer 73 can also be formed on the second surface S and the side surface C of the substrate 10. Specifically, the doping type of the first doped polysilicon material layer 72 is opposite to that of the substrate 10. When the first doped polysilicon material layer 72 is a p-type doped layer, the first mask material layer 73 can be borosilicate glass (BSG), silicon oxide, or the like. It should be understood that, during the formation of the first doped polysilicon material layer 72, an inward diffusion layer can also be formed at a corresponding position in the substrate 10.
Step 3: Referring to FIG. 9, the first mask material layer 73 is patterned by using a laser device, wherein the second region E (corresponding to the n-type region of the back-contact solar cell) and a part of the isolating region G, i.e., a target region T in the isolating region G are processed with laser. The first region Y (corresponding to the p-type region of the back-contact solar cell) and a marking region B corresponding to a marking structure 50 in the isolating region G are not processed with laser. The target region T encloses the marking region B. Specifically, four marking regions B can be formed, respectively located at four corners of the substrate10, and arranged symmetrically with respect to the center of the substrate 10. In FIG. 9, only one of the marking regions B is shown as an example, and the schematic view of the other marking regions B can be similar to this, and are not described repeatedly herein. In a top view, the shape of the marking region B is rectangular, square, or circular, and the target region T is located at the periphery of the marking region B. Then, referring to FIG. 10, the portion of the first mask material layer 73 on the side surface C and the second surface S is removed by washing with hydrofluoric acid, while the portion of the first mask material layer 73 in the first region Y and the marking region B on the first surface F is retained. The retained portion of the first mask material layer 73 can function as a first mask pattern 730.

Referring to FIG. 11, a wet chemical etching process is performed to completely remove the portions of the first tunneling material layer 71 and the first doped polysilicon material layer 72 that are deposited in the laser processed regions (i.e., the second region E and the target region T) and that wrap around the side surface C and the second surface S, so as to form a first emitter structure 20, and to form a stack of a first layer 51 and a second layer 52 from the first tunneling material layer 71 and the first doped polysilicon material layer 72 in the marking region B, thereby forming the marking structure 50. During the formation of the first emitter structure 20 at the position corresponding to the first region Y, a first inward diffusion layer 205 (not shown in FIG. 11) can also be formed in the substrate 10 corresponding to the first region Y and the marking region B.

Step 4: Referring to FIG. 12, an ultra-thin tunneling layer with a thickness ranged from 1nm to 5 nm is formed on the first surface F of the substrate 10 and servers as a second tunneling material layer 81. A second doped polysilicon material layer 82 with a thickness ranged from 100 nm to 500 nm is deposited on the surface of the second tunneling material layer 81 away from the substrate 10. The second tunneling material layer 81 and the second doped polysilicon material layer 82 are collectively referred to as a second material layer 80. A second mask material layer 83 is then deposited on the surface of the second doped polysilicon material layer 82 away from the substrate 10. During the above steps, the second tunneling material layer 81, the second doped polysilicon material layer 82, and the second mask material layer 83 can also be formed on the side surface C and the second surface S. Specifically, the doping type of the second doped polysilicon material layer 82 is the same as that of the substrate 10. As such, the first mask material layer 73, the second tunneling material layer 81, the second doped polysilicon material layer 82, and the second mask material layer 83 are stacked on the marking structure 50 at the position of the marking region B. The morphology of the marking region B and the surrounding target region T is shown in FIGs. 13 and 14. It should be understood that, during the formation of the second doped polysilicon material layer 82, an inward diffusion layer can also be formed at a corresponding position of the substrate 10.

Step 5: Referring to FIG. 15, through four-point positioning using the four marking structures 50, and the portion of the first mask material layers 73, the second tunneling material layers 81, the second doped polysilicon material layers 82, and the second mask material layers 83 that is stacked on the marking structures 50 as four positioning references, the second mask material layer 83 is patterned by using a laser device, wherein the first region Y and the isolating region G are processed with laser, and the width of the isolating region G is approximately in a range from 20 µm to 500 µm.

The portion of the second mask material layer 83 on the side surface C and the second surface S is removed by washing with hydrofluoric acid, while portion of the second mask material layer 83 in the second region E is retained. The retained portion of the second mask material layer 83 can function as a second mask pattern 830.

Step 6: Referring to FIG. 16, a wet chemical process is performed to completely remove the portions of the second tunneling material layer 81 and the second doped polysilicon material layer 82 that are deposited in the laser processed regions (i.e., the first region Y and the isolating region G) and that wrap around the side surface C and the second surface S, so as to form a second emitter structure 30 covering the second region E and form an insulative isolating groove 40 in the target region T, isolating the first emitter structure 20 from the second emitter structure 30. Further, a second inward diffusion layer 304 (not shown in FIG. 16) can also be formed in the second region E. Referring to FIG. 2C, in this process, a fist portion 401 and a second portion 402 can be formed at the bottom of the insulative isolating groove 40.

The surface in the target region T and the second surface S is textured by washing with an alkaline solution to form a textured surface structure 41. The morphology of the textured surface in the target region T includes randomly distributed micron-sized pyramidal structures. The morphology of the marking structure 50 can refer to FIGs. 17 and 18. Since the surface of the marking structure 50 is relatively flat, the reflectivity of the surface of the marking structure 50 is higher than the reflectivity of the bottom of the insulative isolating groove 40 with the textured surface structure 41 in the target region T. As a result, a relatively significant morphological difference can be obtained for positioning, and the accuracy of the location of the electrodes that are subsequently formed by taking the marking structure 50 as a positioning reference can be relatively high.

The surface in the isolating region G can alternatively be a polished surface, or an uneven surface with corroded pits or not polished. Particularly, after this step, the second tunneling material layer 81, the second doped polysilicon material layer 82, and the second mask material layer 83 from the surface of the marking structure 50, and the only three layers remained in the marking region B are the first tunneling material layer 71, the first doped polysilicon material layer 72, and the first mask material layer 73.

Then, the first mask material layer 73 is removed from the surface of the first emitter structure 20, the second mask material layer 83 is removed from the surface of the second emitter structure 30 by washing the first surface F with hydrofluoric acid solution.

Step 7: Referring to FIG. 19, a first passivation layer 61 is formed on the first surface F of the substrate 10. The first passivation layer 61 can be a single film or multiple films, made of a material selected from silicon nitride, aluminum oxide, titanium oxide, silicon oxide, silicon oxynitride, or any combinations thereof. A second passivation layer 62 is formed on the second surface S of the substrate 10. The second passivation layer 62 can include a passivation layer 621 and an anti-reflection layer 622. The passivation layer 621 can be a single film or multiple films, made of a material selected from silicon nitride, aluminum oxide, titanium oxide, silicon oxide, silicon oxynitride, or any combinations thereof. The anti-reflection layer 622 can be a single film or multiple films, made of a material selected from silicon nitride, silicon oxynitride, or a combination thereof. After this step, the marking structure 50 formed in the marking region B is covered with the first passivation layer 61. The marking structure 50 includes a first layer 51 and a second layer 52 formed from the first tunneling material layer 71 and the first doped polysilicon material layer 72, respectively, which are the same as the layers in the first emitter structure 20.

Step 8: Referring to FIGs. 19 and 2A, by using the marking structure 50 and the first passivation layer 61 stacked thereon as a positioning reference, a first electrode 91 is formed on the first passivation layer 61 corresponding to the position of the first emitter structure 20, and a second electrode 92 is formed on the first passivation layer 61 corresponding to the position of the second emitter structure 30. The first electrode 91 passes through the first passivation layer 61 and is electrically connected to the first doped polysilicon layer 22 of the first emitter structure 20. The second electrode 92 passes through the first passivation layer 61 and is electrically connected to the second doped polysilicon layer 32 of the second emitter structure 30. The first electrode 91 and the second electrode 92 have opposite electrical conductivity types. As such, a back-contact solar cell 100 as shown in FIG. 2A can be formed.

In this process, the first electrode 91 and the second electrode 92 can be formed by screen printing an electrode slurry at the location that can be positioned by taking the captured image of the marking structure 50 and the first passivation layer 61 stacked thereon as the positioning reference formed in step 7. Particularly, since the surface of the first passivation layer 61 stacked on the surface of the marking structure 50 is relatively flat, the reflectivity of the surface of the first passivation layer 61 is higher than the reflectivity of the target region T with the textured surface structure 41. Thus, a relatively significant morphological difference can be obtained from the image captured by a camera for positioning of the screen printing, which improves the accuracy of positioning. Optionally, the method for forming the first electrode 91 and the second electrode 92 is not limited to screen printing, and can involve other processes.

An embodiment of the present application further provides a back-contact solar cell 100 prepared by the above-described method for preparing the back-contact solar cell.

An embodiment of the present application further provides a photovoltaic module and a photovoltaic system. The photovoltaic module includes at least one cell string, wherein the cell string includes at least two back-contact solar cells 100 as described above. The solar cells 100 can be connected together by series welding.

The photovoltaic system includes the above-described photovoltaic module. The photovoltaic system can be applied to photovoltaic power stations, such as ground power stations, roof power stations, water surface power stations, etc., and can be applied to equipment or devices that use solar energy to generate electricity, such as user solar power supplies, solar street lights, solar cars, solar buildings, etc. It should be understood that the application scenarios of the photovoltaic system are not limited to the above, in other words, the photovoltaic system can be applied in all fields that need to use solar energy to generate electricity. Taking a photovoltaic power generation network as an example, the photovoltaic system can include a photovoltaic array, a combiner box, and an inverter. The photovoltaic array can be an array of multiple photovoltaic modules. For example, the multiple photovoltaic modules can form multiple photovoltaic arrays. The photovoltaic arrays are connected to the combiner box, which can combine the electrical currents generated by the photovoltaic arrays. The combined electrical current flows through the inverter and is converted into the alternating current suitable for the urban power grid, and then connected to the urban power grid to realize solar power supply.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present application.

The above-described embodiments are only several implementations of the present application, and the descriptions are relatively specific and detailed, but they should not be construed as limiting the scope of the present application. It should be understood by those of ordinary skill in the art that various modifications and improvements can be made without departing from the concept of the present application, and all fall within the protection scope of the present application. Therefore, the patent protection of the present application shall be defined by the appended claims.

## Claims

1. A back-contact solar cell comprising:
a substrate (10);
a first emitter structure (20) disposed on a first surface (F) of the substrate;
a second emitter structure (30) disposed on the first surface of the substrate, wherein a doping type of the first emitter structure is opposite to a doping type of the second emitter structure, the first emitter structure and the second emitter structure are alternately disposed and spaced apart from each other in a first preset direction (F1), and an insulative isolating groove (40) is defined between the first emitter structure and the second emitter structure; and
a marking structure (50) disposed in the insulative isolating groove and spaced apart from both the first emitter structure and the second emitter structure.

2. The back-contact solar cell according to claim 1, wherein a bottom of the insulative isolating groove comprises a first portion (401) and a second portion (402), the first portion extends to the first surface in a thickness direction of the substrate, the marking structure is located at the second portion and protrudes from the first surface towards a direction away from the substrate along the thickness direction of the substrate.

3. The back-contact solar cell according to claim 2, wherein a reflectivity of a surface of the marking structure away from the substrate is different from a reflectivity of a surface of the first portion; preferably:
the reflectivity of the surface of the marking structure away from the substrate is greater than the reflectivity of the surface of the first portion; and/or
the surface of the marking structure away from the substrate is a polished surface; and at least a part of the surface of the first portion has a textured surface structure (41); and/or
an average roughness of the surface of the marking structure away from the substrate is less than an average roughness of the surface of the first portion.

4. The back-contact solar cell according to any one of claim 1 to 3, wherein the marking structure at least comprises a doped layer, which is substantially same as a doped layer of the first emitter structure; or
the marking structure at least comprises a doped layer, which is substantially same as a doped layer of the second emitter structure;
preferably, the first emitter structure comprises a first tunneling oxide layer (21) and a first doped polysilicon layer (22), the first tunneling oxide layer and the first doped polysilicon layer are stacked on the first surface; and
the marking structure comprises a first layer (51) and a second layer (52), the first layer and the second layer are stacked on the first surface, the first layer and the first tunneling oxide layer are made of a same material, and the second layer and the first doped polysilicon layer are made of a same material.

5. The back-contact solar cell according to any one of claim 1 to 4, wherein a layer structure of the marking structure is different from a layer structure of the first emitter structure, and is different from a layer structure of the second emitter structure.

6. The back-contact solar cell according to any one of claims 1 to 5, wherein the substrate comprises a first inward diffusion layer (205) and a second inward diffusion layer (304) extend from the first surface, a doping type of a dopant in the first inward diffusion layer is same as that of a dopant in the first emitter structure, and a doping type of a dopant in the second inward diffusion layer is same as that of a dopant in the second emitter structure; and
the first inward diffusion layer is located at a position corresponding to the first emitter structure and the marking structure, and the second inward diffusion layer is located at a position corresponding to the second emitter structure;
preferably, a thickness of the first inward diffusion layer is greater than a thickness of the second inward diffusion layer;
preferably, the thickness of the first inward diffusion layer is in a range from 50 nm to 200 nm, and the thickness of the second inward diffusion layer is in a range from 20 nm to 100 nm.

7. The back-contact solar cell according to any one of claims 1 to 6, further comprising a first electrode (91) and a second electrode (92);
wherein the first electrode is disposed on a side of the first emitter structure away from the substrate, and is electrically connected to a doped layer of the first emitter structure; and
the second electrode is disposed on a side of the second emitter structure away from the substrate, and is electrically connected to a doped layer of the second emitter structure.

8. The back-contact solar cell according to any one of claims 1 to 7, wherein the first emitter structure comprises a first main structure (201) and first digit structures (202), and the second emitter structure comprises a second main structure (301) and second digit structures (302);
the first main structure of the first emitter structure and the second main structure of the second emitter structure are alternately disposed and spaced apart from each other in the first preset direction;
each first main structure is connected to at least two of the first digit structures, the at least two of the first digit structures are spaced apart from each other in a second preset direction (F2), and each second main structure is connected to at least two of the second digit structures, the at least two of the second digit structures are spaced apart from each other in the second preset direction, and the first preset direction and the second preset direction intersect with each other and are both perpendicular to a thickness direction of the back-contact solar cell;
the first digit structures and the second digit structures that are located between the first main structure and the second main structure that are adjacent to each other are interdigitated with each other in the first preset direction; and
the marking structure is located in a region where the first digit structure and the second digit structure that are interdigitated with each other.

9. The back-contact solar cell according to claim 8, wherein the marking structure is located between one first digit structure and one second digit structure adjacent to each other in the second preset direction.

10. The back-contact solar cell according to claim 8, wherein the first digit structures and the second digit structures located between the first main structure and the second main structure are alternately disposed in the second preset direction;
the marking structure is located at an end of one first digit structure away from the first main structure in the first preset direction; or
the marking structure is located at an end of one second digit structure away from the second main structure in the first preset direction.

11. The back-contact solar cell according to claim 10, wherein the marking structure is located at the end of the second digit structure away from the second main structure in the first preset direction;
the first emitter structure further comprises a first connecting structure (203), and two adjacent first digit structures are connected to each other via the first connecting structure in the second present direction;
the marking structure is located between the first connecting structure and a corresponding second digit structure in the first preset direction, and the second digit structure is inserted between the two adjacent first digit structures in the second preset direction.

12. The back-contact solar cell according to claim 10, wherein the marking structure is located at the end of the first digit structure away from the first main structure in the first preset direction;
the second emitter structure further comprises a second connecting structure (303), and two adjacent second digit structures are connected to each other via the second connecting structure in the second present direction;
the marking structure is located between the second connecting structure and a corresponding first digit structure in the first preset direction, and the corresponding first digit structure is inserted between the two adjacent second digit structures in the second preset direction.

13. The back-contact solar cell according to any one of claims 7 to 12, wherein the first electrode comprises a first busbar (911) and first finger electrodes (912) electrically connected to the first busbar, the second electrode comprises a second busbar (921) and second finger electrodes (922) electrically connected to the second busbar; and
the first busbar and the first finger electrodes are correspondingly disposed on the first main structure and the first digit structures, respectively, and the second busbar and the second finger electrodes are correspondingly disposed on the second main structure and the second digit structures, respectively.

14. The back-contact solar cell of any one of claims 7 to 13, wherein the first electrode comprises a first busbar and first finger electrodes, and the second electrode comprises a second busbar and second finger electrodes;
the first busbar and the second busbar are alternately disposed and spaced apart from each other in the first preset direction;
each first busbar is connected to at least two of the first finger electrodes, the at least two of the first finger electrodes are spaced apart from each other in a second preset direction, each second busbar is connected to at least two of the second finger electrodes, the at least two of the first finger electrodes are spaced apart from each other in a second preset direction, and the first preset direction and the second preset direction intersect with each other and are both perpendicular to a thickness direction of the back-contact solar cell;
the first finger electrodes and the second finger electrodes located between the first busbar and the second busbar are interdigitated with each other; and
the marking structure is located in a region where the first finger electrodes and the second finger electrodes are interdigitated with each other.

15. The back-contact solar cell according to claim 14, wherein the marking structure is located between one first finger electrode and one second finger electrode adjacent to each other in the second preset direction.

16. The back-contact solar cell according to claim 14, wherein the first finger electrodes and the second finger electrodes located between the first busbar and the second busbar are alternately disposed in the second preset direction;
the marking structure is located at an end of one first finger electrode away from the first busbar in the first preset direction, and a distance between a center of the marking structure and the first busbar is greater than or equal to a distance between the center of the marking structure and the second busbar; or
the marking structure is located at an end of one second finger electrode away from the second busbar in the first preset direction, and a distance between a center of the marking structure and the second busbar is greater than or equal to a distance between the center of the marking structure and the first busbar.

17. The back-contact solar cell according to claim 16, wherein both the first finger electrodes and the second finger electrodes extend in the first preset direction;
the marking structure is located at the end of the second finger electrode away from the second busbar in the first preset direction; and
the first electrode further comprises a first connecting line (913) located between two adjacent first finger electrodes, the marking structure is located between the second finger electrode and the first connecting line in the first preset direction, and the second finger electrode is inserted between the two adjacent first finger electrodes in the second preset direction.

18. The back-contact solar cell according to claim 16, wherein the marking structure is located at the end of the first finger electrode away from the first busbar in the first preset direction; and
the second electrode further comprises a second connecting line (923) located between two adjacent second finger electrodes, the marking structure is located between the first finger electrode and the second connecting line in the first preset direction, and the first finger electrode is inserted between the two adjacent second finger electrodes in the second preset direction.

19. A method for preparing a back-contact solar cell, comprising:
forming a first emitter structure and a marking structure respectively on a first region (Y) and a marking region (B) of a first surface of a substrate, with a first mask pattern (730) being stacked on a surface of the first emitter structure and a surface of the marking structure away from the substrate, wherein the first surface further comprises a second region (E) and an isolating region (G), the first region and the second region are alternately arranged in a first preset direction, the isolating region is located between the first region and the second region adjacent to each other, thereby isolating the first region from the second region, the marking region is located in the isolating region, and an outer contour of the marking region is spaced apart from an outer contour of the isolating region;
forming a second emitter material layer (80) and a second mask material layer (83) covering at least an entire first surface, wherein the second emitter material layer and the second mask material layer are stacked on a side of the first mask pattern away from the substrate; and
taking the marking structure, and the portion of the first mask pattern, the second emitter material layer, and the second mask material layer that is stacked on the marking structure as a positioning reference, forming the portion of the second emitter material layer located in the second region into a second emitter structure, and forming an insulative isolating groove corresponding to the isolating region and between the first emitter structure and the second emitter structure.
